(19) **Europäisches Patentamt / European Patent Office / Office européen des brevets**

(11) **EP 4 579 949 A1**

(12) # EUROPEAN PATENT APPLICATION

(43) Date of publication:
02.07.2025 Bulletin 2025/27

(21) Application number: 24216193.3

(22) Date of filing: 28.11.2024

(51) International Patent Classification (IPC):
*H01Q 1/22* (2006.01)     *H01Q 1/42* (2006.01)
*H01Q 3/34* (2006.01)     *H01Q 5/307* (2015.01)
*H01Q 1/02* (2006.01)

(52) Cooperative Patent Classification (CPC):
**H01Q 1/2266; H01Q 1/2283; H01Q 1/2291;
H01Q 1/42; H01Q 3/34; H01Q 5/307;** H01Q 1/02

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 28.12.2023 US 202318398344

(71) Applicant: **Intel Corporation
Santa Clara, CA 95054 (US)**

(72) Inventors:
• **GUPTA, Jay Vishnu**
  560103 Bangalore (IN)
• **DAS, Sajal Kumar**
  560115 Bangalore (IN)
• **GUPTA, Sagar**
  201002 Ghaziabad (IN)
• **HEGDE, Mythili**
  560078 Bangalore, Karnataka (IN)

• **PEDDIREDDY, Prathibha**
  560087 Bangalore (IN)
• **AGARWAL, Anshu**
  560037 Bangalore (IN)
• **KROVVIDI, Srinivas**
  500090 Telengana (IN)
• **PATTANAIK, Vatsala**
  560066 Karnataka Bangalore (IN)
• **SANGLE, Parshuram**
  560018 Bengaluru (IN)
• **R, Aneesh**
  560066 Bangalore, Karnataka (IN)
• **PAMMI, Lakshmiravikanth**
  534112 Andhra Pradesh (IN)
• **THAKUR, Jayprakash**
  560035 Bangalore (IN)
• **KUMAR, Brijesh**
  282007 Agra, Uttar Pradesh (IN)

(74) Representative: **2SPL Patentanwälte PartG mbB
Landaubogen 3
81373 München (DE)**

(54) **SYSTEMS FOR USER DEVICE ANTENNA PLACEMENT AND POWER SAVINGS**

(57) A method for defining antenna in module (AiM) placement within a user device can include configuring a simulation of antenna gain of antenna in module (AiM) components. The simulation can include as an output a cumulative distribution function (CDF) representing AiM coverage. The method can include identifying a first parameter of a set of antenna in module (AiM) placement parameters that has a largest effect on an antenna performance criterion observed in the simulation. The method can include adjusting other parameters based on the first parameter and specifying final placement of the AiM. An apparatus can include antennas and a radio front end including active circuitry and passive circuitry. The passive circuitry can be energized by a signal at a center frequency for the apparatus. The passive circuitry can store electrical charge and power on the active circuitry when charge reaches a threshold.

FIG. 1

**EP 4 579 949 A1**

## Description

## TECHNICAL FIELD

Aspects of the disclosure pertain to radio frequency (RF) communications. More particularly, aspects relate to antenna location and power savings for RF communications.

## BACKGROUND

User devices today typically include multiple antennas. The location of these antennas within user device chasses can affect antenna gain, thermal profiles, and device weight and usability. Other devices (including Internet of Things (IoT) devices) can have limited power or battery capacity, and it is desirable to keep these devices powered down as often as possible.

## BRIEF DESCRIPTION OF THE DRAWINGS

In the drawings, which are not necessarily drawn to scale, like numerals may describe similar components in different views. Like numerals having different letter suffixes may represent different instances of similar components. Some aspects are illustrated by way of example, and not limitation, in the figures of the accompanying drawings in which:

FIG. 1 illustrates an exemplary user device according to some aspects.
FIG. 1A illustrates a mmWave system, which can be used in connection with the device of FIG. 1 according to some aspects.
FIG. 2A illustrates exemplary wireless communication circuitry according to some aspects.
FIG. 2B illustrates aspects of exemplary transmit circuitry illustrated in FIG. 2A according to some aspects.
FIG. 2C illustrates aspects of exemplary transmit circuitry illustrated in FIG. 2A according to some aspects.
FIG. 2D illustrates aspects of exemplary radio frequency circuitry illustrated in FIG. 2A according to some aspects.
FIG. 2E illustrates aspects of exemplary receive circuitry in FIG. 2A according to some aspects.
FIG. 3 illustrates exemplary useable RF circuitry in FIG. 2A according to some aspects.
FIG. 4A illustrates an aspect of an exemplary radio front end module (RFEM) according to some aspects.
FIG. 4B illustrates an alternate aspect of an exemplary radio front end module, according to some aspects.
FIG. 5A shows the multiple directions with respect to a user device (e.g., laptop).
FIG. 5B illustrates lid/AiM interaction that contributes to thermal impact.
FIG. 6 illustrates a C-cover view of a user device such as a laptop.
FIG. 6A is a sidewall view of FIG. 6.
FIG. 6B is a cross sectional view of FIG. 6.
FIG. 7A and FIG. 7B illustrate transmission characteristics of a dielectric slab.
FIG. 8 illustrate a method for deriving parameters for AiM placement in a user device in accordance with some aspects.
FIG. 9 illustrates correlation between different parameters and impact (if violated) on the steered radiation beams or gain of the antenna.
FIG. 10 illustrates CDF coverage comparison given different combinations of AiMs according to some aspects.
FIG. 11 illustrates a method for defining AiM parameters in accordance with some embodiments.
FIG. 12 is a block diagram of a solution for remote wireless device On/Off using passive circuit elements to avoid Idle mode power consumption in accordance with some aspects.
FIG. 13 is a circuit diagram of a solution using passive circuit components of a wireless device modem front-end block to implement methods in accordance with some aspects.
FIG. 14 illustrates a method for waking devices using passive circuitry in accordance with some aspects of the disclosure.
FIG. 15 illustrates a block diagram of a communication device such as an evolved Node-B (eNB), a new generation Node-B (gNB), an access point (AP), a wireless station (STA), a mobile station (MS), or a user equipment (UE), in accordance with some aspects.
FIG. 16 illustrates a system level diagram, depicting an example of an electronic device (e.g., system) that can include, for example, a transmitter configured to selectively fan out a signal to one of multiple communication channels.

## DETAILED DESCRIPTION

The following description and the drawings sufficiently illustrate specific aspects to enable those skilled in the art to practice them. Other aspects may incorporate structural, logical, electrical, process, and other changes. Portions and features of some aspects may be included in, or substituted for, those of other aspects. Aspects set forth in the claims encompass all available equivalents of those claims.
Antenna-in-Module (AiM) is an antenna technology used in modem computing systems to provide reconfigurable antenna arrays for 5G applications at millimeter-wave (mmWave) frequencies. Beam steering is used to cover multiple directions with high gain directional radiation. AiM placement should be made to fit in thin and light fanless system without impacting thermal profiles of those devices. Technical challenges can arise in determining AiM placement that will provide adequate coverage while maintaining thin and light user systems and with consideration to thermal impacts in fanless user systems.

Power consumption is also important for portable electronic devices including Internet of Things (IoT) devices in 5G Massive Machine Type Communication (mMTC). Previous solutions for IoT often included providing longer sleep cycles to reduce power consumption. However, devices still must wake periodically to check for messages from central systems.

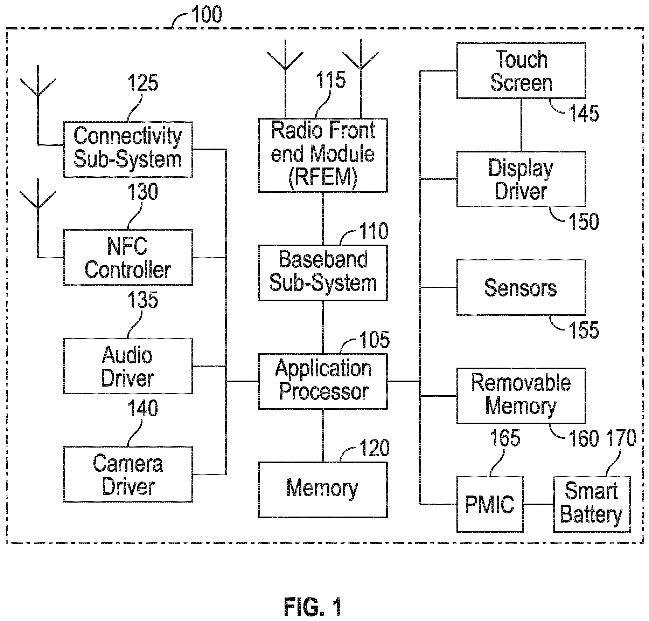

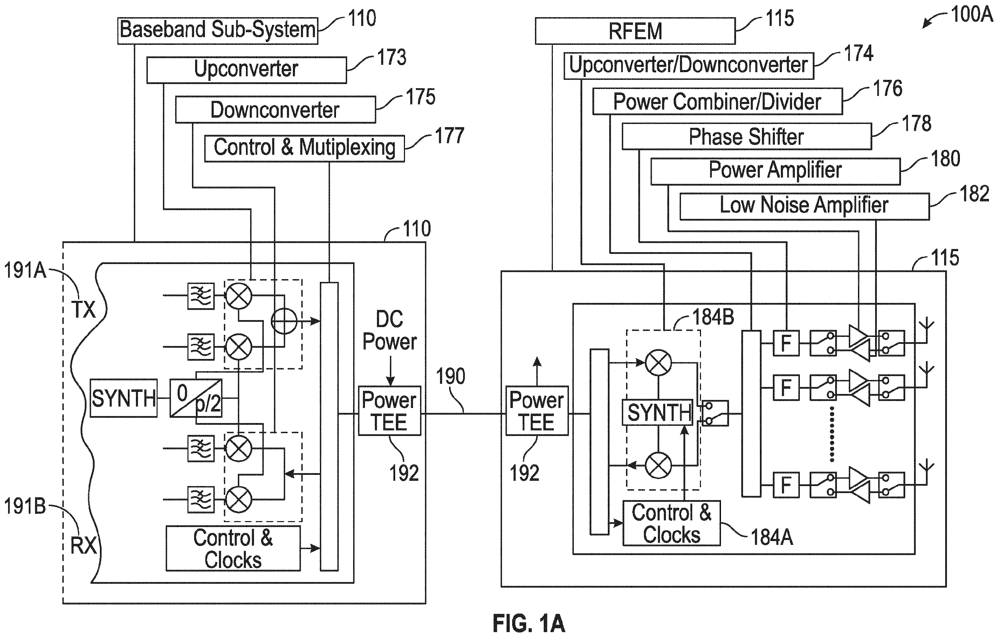

Aspects of the disclosure address these and other concerns by providing design criteria and setting AiM placement parameters to meet the more critical design criteria while maintaining coverage and reducing thermal impact. Other aspects reduce device power consumption by providing circuitry to wake devices only when a message is intended for that given device, and to allow the device to remain in sleep mode otherwise. The communication systems, devices, and other components determining AiM placement and for allowing devices to save power by remaining asleep are described in more detail with respect to FIG. 1-4B.

An integrated Radio-Frequency frontend module (FEM) is broadly used in the frontend circuits for cellular handsets or other wireless devices. FIG. 1 illustrates an exemplary user device according to some aspects. The user device 100 may be a mobile device in some aspects and includes an application processor 105, base-band processor 110 (also referred to as a base-band sub-system), radio front end module (RFEM) 115, memory 120, connectivity sub-system 125, near field communication (NFC) controller 130, audio driver 135, camera driver 140, touch screen 145, display driver 150, sensors 155, removable memory 160, power management integrated circuit (PMIC) 165, and smart battery 170.

In some aspects, application processor 105 may include, for example, one or more central processing unit (CPU) cores and one or more of cache memory, low drop-out voltage regulators (LDOs), interrupt controllers, serial interfaces such as serial peripheral interface (SPI), inter-integrated circuit (I2C) or universal programmable serial interface sub-system, real time clock (RTC), timer-counters including interval and watchdog timers, general purpose IO, memory card controllers such as SD/MMC or similar, USB interfaces, mobile industry processor interface (MIPI) interfaces, and/or Joint Test Access Group (JTAG) test access ports.

In some aspects, base-band processor 110 may be implemented, for example, as a solder-down substrate including one or more integrated circuits, a single packaged integrated circuit soldered to a main circuit board, and/or a multi-chip module including two or more integrated circuits.

Applications of mmWave technology can include, for example, WiGig and future 5G, but the mmWave technology can be applicable to a variety of telecommunications systems. The mmWave technology can be especially attractive for short-range telecommunications systems. WiGig devices operate in the unlicensed 60 GHz band, whereas 5G mmWave is expected to operate initially in the licensed 28 GHz and 39 GHz bands. A block diagram of an example base-band processor 110 and RFEM 115 in a mmWave system is shown in FIG. 1A.

FIG. 1A illustrates a mmWave system 100A, which can be used in connection with the device 100 of FIG. 1 according to some aspects of the present disclosure. The system 100A includes two components: a base-band processor 110 and one or more radio front end modules (RFEMs) 115. The RFEM 115 can be connected to the base-band processor 110 by a single coaxial cable 190, which supplies a modulated intermediate frequency (IF) signal, DC power, clocking signals and control signals.

The base-band processor 110 is not shown in its entirety, but FIG. 1A rather shows an implementation of analog front end. This includes a transmitter (TX) section 191A with an upconverter 173 to intermediate frequency (IF) (around 10 GHz in current implementations), a receiver (RX) section 191B with downconversion 175 from IF to baseband, control, and multiplexing circuitry 177 including a combiner to multiplex/demultiplex transmit and receive signals onto a single cable 190. In addition, power tee circuitry 192 (which includes discrete components) is included on the base-band circuit board to provide DC power for the RFEM 115. In some aspects, the combination of the TX section and RX section may be referred to as a transceiver, to which may be coupled one or more antennas or antenna arrays of the types described herein.

The RFEM 115 can be a small circuit board including a number of printed antennas and one or more RF devices containing multiple radio chains, including upconversion/downconversion 174 to millimeter wave frequencies, power combiner/divider 176, programmable phase shifting 178 and power amplifiers (PA) 180, low noise amplifiers (LNA) 182, as well as control and power management circuitry 184A and 184B. This arrangement can be different from Wi-Fi or cellular implementations, which generally have all RF and base-band functionality integrated into a single unit and only antennas connected remotely via coaxial cables.

This architectural difference can be driven by the very large power losses in coaxial cables at millimeter wave frequencies. These power losses can reduce the transmit power at the antenna and reduce receive sensitivity. In order to avoid this issue, in some aspects, PAs 180 and LNAs 182 may be moved to the RFEM 115 with integrated antennas. In addition, the RFEM 115 may include upconversion / downconversion 174 so that the IF signals over the coaxial cable 190 can be at a lower frequency. Additional system context for mmWave 5G apparatuses, techniques and features is discussed herein below.

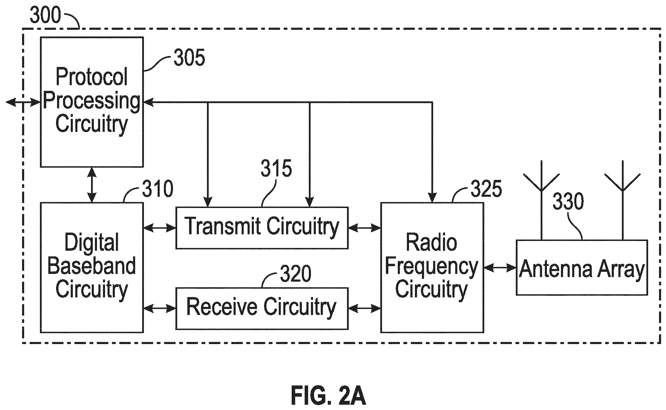

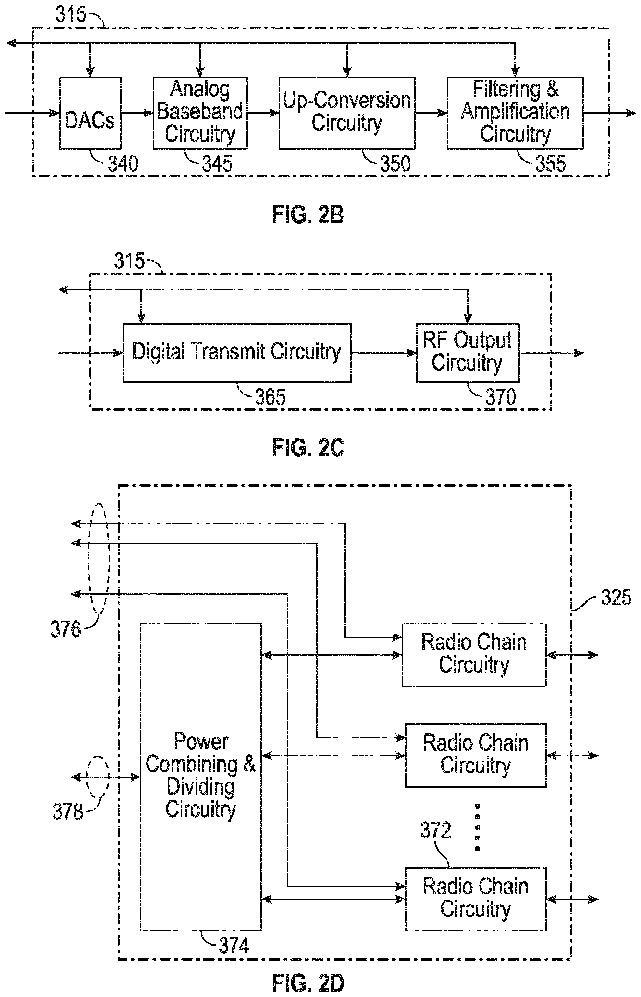

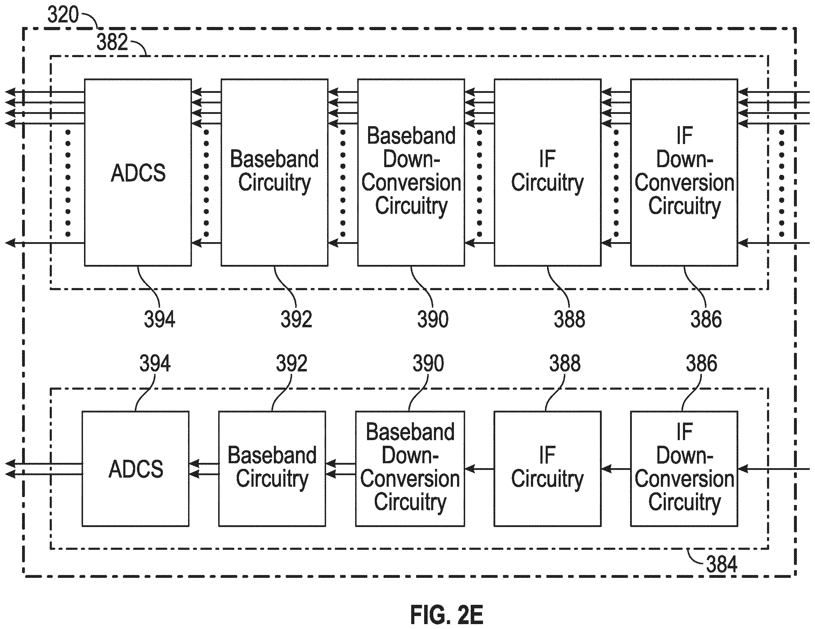

FIG. 2A illustrates exemplary wireless communication circuitry according to some aspects; FIGS. 2B and 2C illustrate aspects of transmit circuitry shown in FIG. 2A according to some aspects; FIG. 2D illustrates aspects of radio frequency circuitry shown in FIG. 2A according to some aspects; FIG. 2E illustrates aspects of receive circuitry in FIG. 2A according to some aspects. Wireless communication circuitry 300 shown in FIG. 2A may be alternatively grouped according to functions. Components illustrated in FIG. 2A are provided here for illustrative purposes and may include other components not shown in FIG. 2A.

Wireless communication circuitry 300 may include protocol processing circuitry 305 (or processor) or other means for processing. Protocol processing circuitry 305 may implement one or more of medium access control (MAC), radio link control (RLC), packet data convergence protocol (PDCP), radio resource control (RRC) and non-access stratum (NAS) functions, among others. Protocol processing circuitry 305 may include one or more processing cores to execute instructions and one or more memory structures to store program and data information.

Wireless communication circuitry 300 may further include digital base-band circuitry 310. Digital base-band circuitry 310 may implement physical layer (PHY) functions including one or more of hybrid automatic repeat request (HARQ) functions, scrambling and/or descrambling, coding and/or decoding, layer mapping and/or de-mapping, modulation symbol mapping, received symbol and/or bit metric determination, multi-antenna port precoding and/or decoding which may include one or more of space-time, space-frequency or spatial coding, reference signal generation and/or detection, preamble sequence generation and/or decoding, synchronization sequence generation and/or detection, control channel signal blind decoding, and other related functions.

Wireless communication circuitry 300 may further include transmit circuitry 315, receive circuitry 320 and/or antenna array circuitry 330. Wireless communication circuitry 300 may further include RF circuitry 325. In some aspects, RF circuitry 325 may include one or multiple parallel RF chains for transmission and/or reception. Each of the RF chains may be connected to one or more antennas of antenna array circuitry 330.

In some aspects, protocol processing circuitry 305 may include one or more instances of control circuitry. The control circuitry may provide control functions for one or more of digital base-band circuitry 310, transmit circuitry 315, receive circuitry 320, and/or RF circuitry 325.

FIGS. 2B and 2C illustrate aspects of transmit circuitry shown in FIG. 2A according to some aspects. Transmit circuitry 315 shown in FIG. 2B may include one or more of digital to analog converters (DACs) 340, analog base-band circuitry 345, up-conversion circuitry 350 and/or filtering and amplification circuitry 355. DACs 340 may convert digital signals into analog signals. Analog base-band circuitry 345 may perform multiple functions as indicated below. Up-conversion circuitry 350 may up-convert base-band signals from analog base-band circuitry 345 to RF frequencies (e.g., mmWave frequencies). Filtering and amplification circuitry 355 may filter and amplify analog signals. Control signals may be supplied between protocol processing circuitry 305 and one or more of DACs 340, analog base-band circuitry 345, up-conversion circuitry 350 and/or filtering and amplification circuitry 355.

Transmit circuitry 315 shown in FIG. 2C may include digital transmit circuitry 365 and RF circuitry 370. In some aspects, signals from filtering and amplification circuitry 355 may be provided to digital transmit circuitry 365. As above, control signals may be supplied between protocol processing circuitry 305 and one or more of digital transmit circuitry 365 and RF circuitry 370.

FIG. 2D illustrates aspects of radio frequency circuitry shown in FIG. 2A according to some aspects. Radio frequency circuitry 325 may include one or more instances of radio chain circuitry 372, which in some aspects may include one or more filters, power amplifiers, low noise amplifiers, programmable phase shifters and power supplies.

Radio frequency circuitry 325 may also in some aspects include power combining and dividing circuitry 374. In some aspects, power combining and dividing circuitry 374 may operate bidirectionally, such that the same physical circuitry may be configured to operate as a power divider when the device is transmitting, and as a power combiner when the device is receiving. In some aspects, power combining and dividing circuitry 374 may include one or more wholly or partially separate circuitries to perform power dividing when the device is transmitting and power combining when the device is receiving. In some aspects, power combining and dividing circuitry 374 may include passive circuitry including one or more two-way power divider/combiners arranged in a tree. In some aspects, power combining and dividing circuitry 374 may include active circuitry including amplifier circuits.

In some aspects, radio frequency circuitry 325 may connect to transmit circuitry 315 and receive circuitry 320 in FIG. 2A. Radio frequency circuitry 325 may connect to transmit circuitry 315 and receive circuitry 320 via one or more radio chain interfaces 376 and/or a combined radio chain interface 378. In some aspects, one or more radio chain interfaces 376 may provide one or more interfaces to one or more receive or transmit signals, each associated with a single antenna structure. In some aspects, the combined radio chain interface 378 may provide a single interface to one or more receive or transmit signals, each associated with a group of antenna structures.

FIG. 2E illustrates aspects of receive circuitry in FIG. 2A according to some aspects. Receive circuitry 320 may include one or more of parallel receive circuitry 382 and/or one or more of combined receive circuitry 384. In some aspects, the one or more parallel receive circuitry 382 and one or more combined receive circuitry 384 may include one or more Intermediate Frequency (IF) down-conversion circuitry 386, IF processing circuitry 388, baseband down-conversion circuitry 390, base-band processing circuitry 392 and analog-to-digital converter (ADC) circuitry 394. As used herein, the term "intermediate frequency" refers to a frequency to which a carrier frequency (or a frequency signal) is shifted as in intermediate step in transmission, reception, and/or signal processing. IF down-conversion circuitry 386 may convert received RF signals to IF. IF processing circuitry 388 may process the IF signals, e.g., via filtering and amplification. Baseband down-conversion circuitry 390 may convert the signals from IF processing circuitry 388 to baseband. Base-band processing circuitry 392 may process the base-band signals, e.g., via filtering and amplification. ADC circuitry 394 may convert the processed analog base-band signals to digital signals.

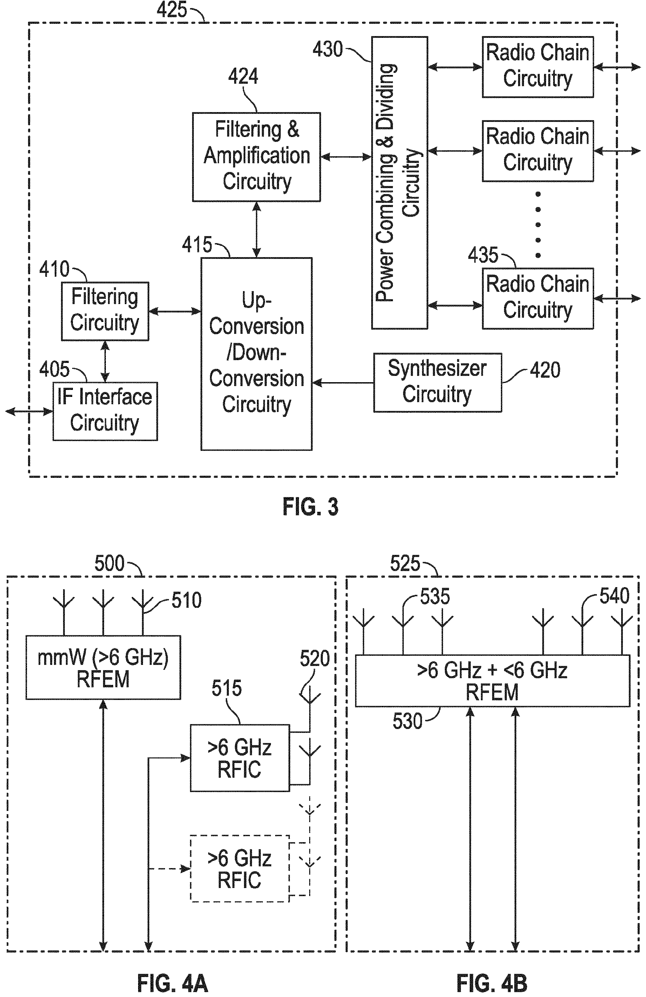

FIG. 3 illustrates exemplary RF circuitry of FIG. 2A according to some aspects. In an aspect, RF circuitry 325 in FIG. 2A (depicted in FIG. 3 using reference number 425) may include one or more of the IF interface circuitry 405, filtering circuitry 410, up-conversion and down-conversion circuitry 415, synthesizer circuitry 420, filtering and amplification circuitry 424, power combining and dividing circuitry 430, and radio chain circuitry 435.

FIG. 4A and FIG. 4B illustrate aspects of a radio front-end module (RFEM) useable in the circuitry shown in FIG. 1, according to some aspects. FIG. 4A illustrates an aspect of a RFEM according to some aspects. RFEM 500 incorporates a millimeter wave RFEM and one or more above-six gigahertz radio frequency integrated circuits (RFIC) 515 and/or one or more sub-six gigahertz RFICs (not shown in FIG. 4A). In this aspect, the one or more sub-six gigahertz RFICs 515 and/or one or more sub-six gigahertz RFICs may be physically separated from millimeter wave RFEM. RFICs 515 may include connection to one or more antennas 520. RFEM may include multiple antennas 510.

FIG. 4B illustrates an alternate aspect of a radio front end module 525, according to some aspects. In this aspect both millimeter wave and sub-six gigahertz radio functions may be implemented in the same physical radio front end module (RFEM) 530. RFEM 530 may incorporate both millimeter wave antennas 535 and sub-six gigahertz antennas 540.

## *Method to optimize mmWave AiM placement*

Any of the above systems described in FIG. 1-4B can be provided in laptops or other devices in which aspects of the present disclosure may be implemented. As described earlier herein, current and future laptop designs may include provide 5G mmWave capability using multiple mmWave AiM modules to be accommodated, in addition to Wi-Fi and 5G sub-6 antennas.

AiM can provide reconfigurable antenna arrays for 5G applications at mmWave frequencies. 5G mmWave bands (FR2) have throughput in the range of Gigabytes with additional capacity. To cover the mentioned frequency bands, antenna systems include an array of antennas in different polarizations. In the context of some aspects, one antenna module may include a 4 x 1 array with 16 ports to steer the beam in particular direction. Typically, one module covers +50° to -50° angles. These numbers and configurations are examples, and aspects of the disclosure are not limited to a particular size array, ports, or range of steering angle.

It can be challenging to determine where to place AiMs in a user device. Users prefer devices to be as thin and light as possible, and furthermore some devices are fanless, which can complicate temperature control. Methods according to some aspects of this disclosure address these and other concerns by optimizing AiM module placement to fit in thin and light fanless system without impacting thermal! or industrial design (ID) considerations.

Methods according to aspects can include identifying the criterion/criteria that are important to laptop operation in multiple bands, prioritizing important design parameters for AiM placement, and determining and recognizing how these parameters can be set to achieve the criterion/criteria. In some examples, through intelligent placement of AiMs, the number of AiMs used can be reduced or minimized while still obtaining desired coverage. For example, in simulation it can be discovered that addition of AiMs does not provide a significant contribution in coverage and therefore the number of AiMs can be reduced without degradation of user experience.

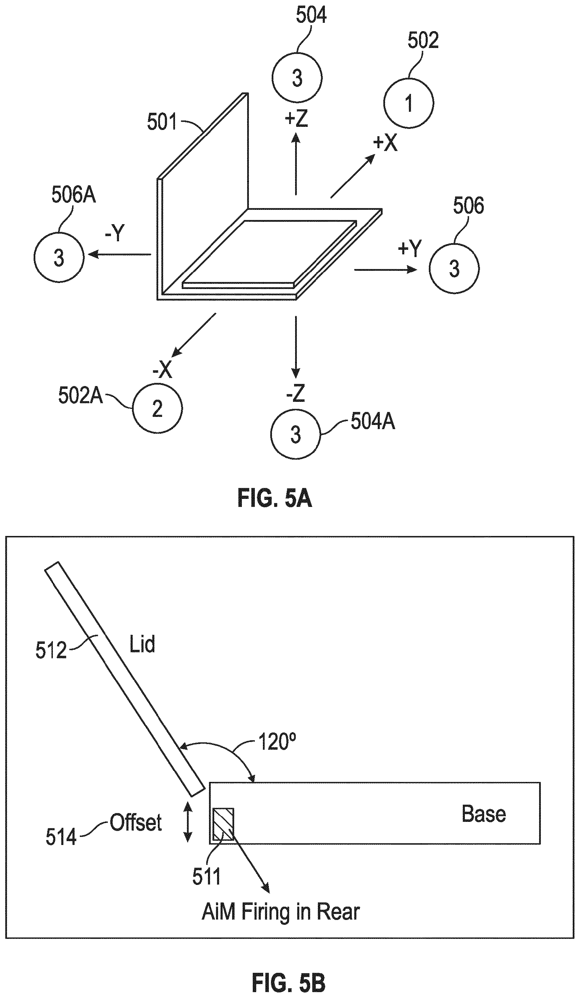

FIG. 5A shows the multiple directions with respect to a user device (e.g., laptop) 501. To cover multiple directions with good connectivity, multiple AiM modules are required. mmWave modules are directional and typically covering from -50° to +50° angle. As AiMs are directional antennas, multiple modules are used to achieve desired Cumulative Distribution Function (CDF) coverage. CDF of Effective Isotropic Radiated Power (EIRP) is a cumulative probability that the EIRP will be less than a given value. As seen in FIG. 5A, the system can be described according to direction 502-502A, direction 504-504A, and direction 506-506A along various axes.

For thin and light fanless full-metal systems 501, chassis metal can be used for thermal dissipation. Any plastics used (mainly in C-cover or top cover) will impact on ID and thermal performance. In FIG. 5A, direction 502-502A does not affect thermal performance but directions 504-504A and 506-506A do impact performance. Therefore, if antennas are placed in directions 504-504A and 506-506A thermal performance can be expected to be impacted. As an example, shown in FIG. 5B with reference to directions described according to FIG. 5A, an AiM 511 placed in the 506A direction will have

an impact because of lid 512 movement and system thermal performance. Also, the lid 512 must be placed in offset position 514 to enable radiation from direction 506A.

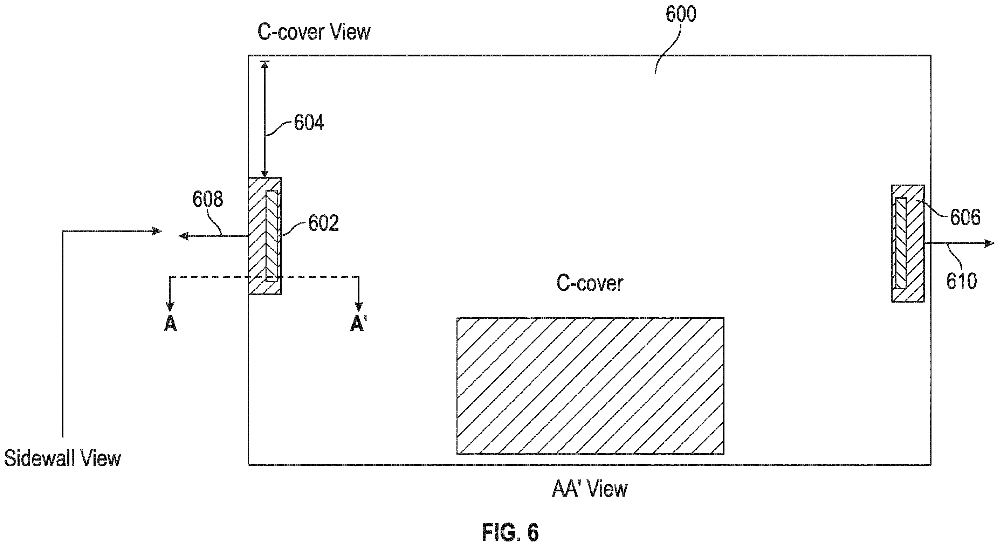

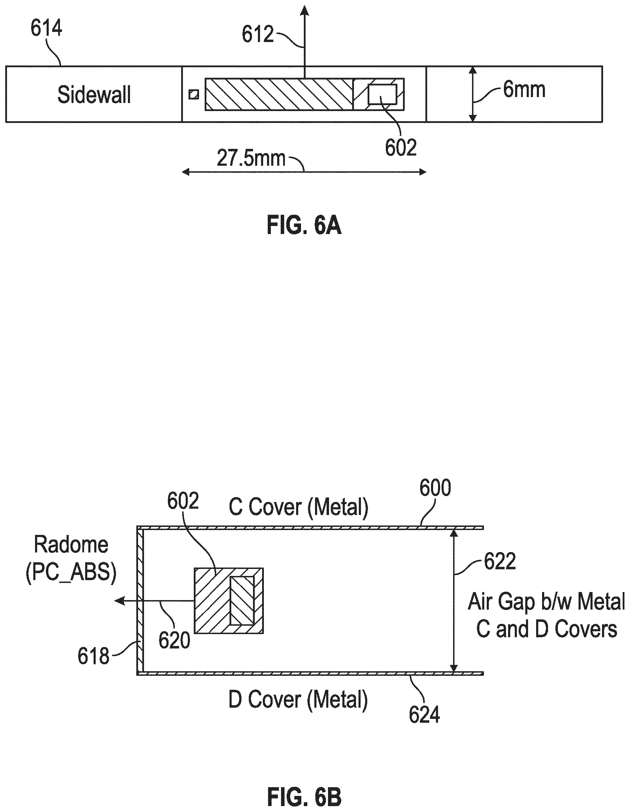

Even with offset 514, however, a negative impact on CDF coverage can occur as the lid 512 obstructs the partial region of +/-50 degrees of radiation. As can be appreciated, therefore, AiM design and placement parameters are important for reducing thermal effects and maintaining coverage. FIG. 6 illustrates a C-cover 600 view of a user device such as a laptop. FIG. 6 is provided for purposes of illustrating AiM design parameters. FIG. 6A is a sidewall view of FIG. 6. FIG. 6B is a cross sectional view of FIG. 6. An AiM 602 can be provided a distance 604 from an edge of the system. The distance can be, for example, at least four times the wavelength $\lambda_{fm}$ of a minimum frequency, where a minimum frequency can be defined as the lowest operating frequency that will be expected during user device operations.

Another AiM module 606 can be provided. While two AiM modules 602, 606 are shown, more or fewer AiM modules may be provided and aspects of the disclosure are not limited to any particular number of AiM modules, although some simulations have shown that two AiM modules 602, 606 are adequate for device operations. AiM modules 602, 606 can be placed in corners of the system with directions 608, 610 because, as described above these directions 608, 610 have been found to have less thermal impact than other possible directions.

Direction 612 can further be seen in the sidewall 614 view shown in FIG. 6A. As seen, the AiM module direction is as shown, toward the air for reduced thermal impact on the rest of the user device. Radome 618 thickness shown in FIG. 6B is another parameter that is important for AiM design as described in more detail below. Other parameters include gap 620 between radome 618 and AiM module 602; offset along a Z-axis (represented by gap 622 between the AiM 602 and the metal C-cover 600 and metal D-cover 624 (e.g., top cover and bottom cover, respectively); and sidewall 614 opening dimensions (e.g., width, length, area). The parameters shown with respect to FIG. 6-6C are important for the AiM placement as to cover multiple frequency bands and support beam steering features. Furthermore, the parameters are sensitive (in the range of millimeters) because the operating frequencies of the AiMs are high (in the range of 40 GHz).

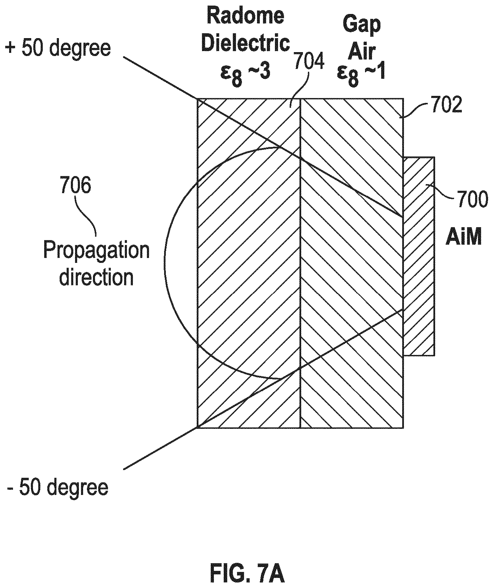

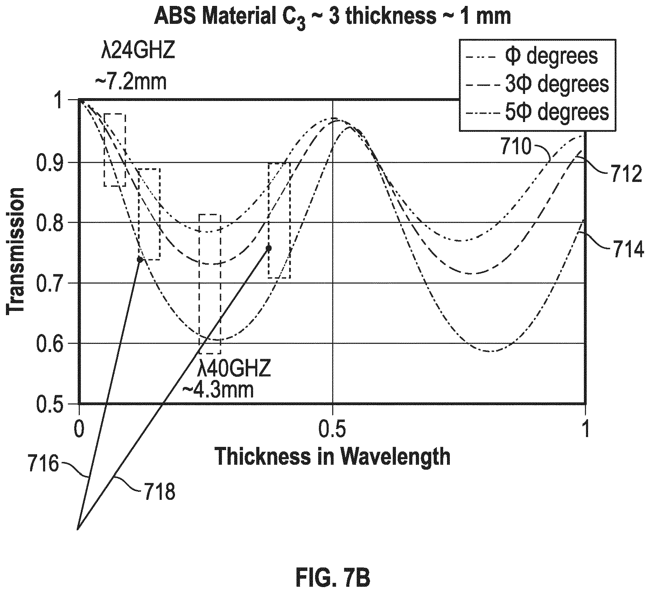

Certain challenges are found in methods for determining AiM placement. First, the radome 618 is plastic material required to protect the AiM from open environment. However, for proper antenna radiation, thickness, and gap from radome 618 to antenna 602 is necessary, as shown in FIG. 7A and FIG. 7B. Otherwise, boresight error can be introduced and directive gain can be affected. Furthermore, as the AiM covers at least two frequencies, air gaps, thickness, etc. should be set for one frequency without overly degrading the other frequency.

**Fehler! Verweisquelle konnte nicht gefunden werden.** FIG. 7A and FIG. 7B illustrate transmission characteristics of a dielectric slab. AiM 700 propagates through air gap 702 having a first permittivity, and encounters radome dielectric 704 (e.g., dielectric slab) having a second permittivity. Propagation direction 706 is expected. Dielectric 704 should have a thickness, and further the gap 702 should have a thickness to achieve boresight error with steered beams (+/- 50 degrees).

FIG. 7B illustrates transmission characteristics of a dielectric slab with thickness h and relative permittivity for different angles of incidence. Curve 710 illustrates transmission characteristics at a zero-degree angle of incidence. Curve 712 illustrates transmission characteristics at a thirty-degree angle of incidence. Curve 714 illustrates transmission characteristics at a fifty-degree angle of incidence. The thickness '1' is chosen such that the phase difference between different incident angles within gap 702 having a given permittivity) is reduced or minimized (preferably zero phase difference, as shown by example indications 716, 718), with a goal of improving 40 Ghz band (e.g., high band or HB) performance with little or no degradation of 24 Ghz band (e.g.., low band or LB). Further, boresight error should be reduced or minimized (or zero) after propagation through the radome dielectric 704. Thickness can be expressed in terms of wavelengths as $\dfrac{h}{\lambda_0}\sqrt{\varepsilon_R}$ , where h is thickness of the dielectric slab 704 and $\varepsilon_r$ is permittivity.

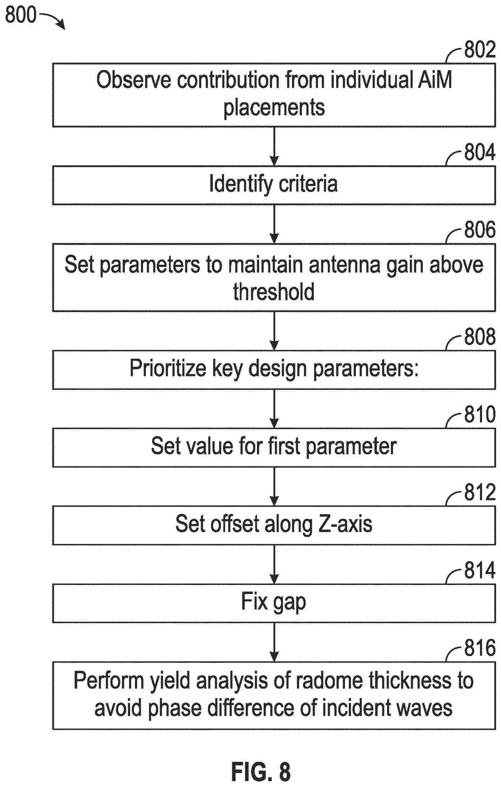

To address these and other concerns, a method 800 such as shown in FIG. 8 can include operations such as examining simulations or other information to determine how and whether to modify parameters to optimize AiM module placement to fit in thin and light fanless systems without impacting on thermal profiles or other user device criteria.

The method 800 can begin in operation 802 with observing the contribution from individual AiM module placements, or combination AiM module placements within a user system. According to some aspects of the disclosure, and as described earlier herein with reference to FIG. 5A, AiM placement is preferred in direction 502/502A, as coverage with (502/502A) placement is better than other placements due to impacts from subsystems such as a lid.

Also, while comparing the coverage performance of (502/502A) with addition of a third AiM, it was found that the contribution from the third AiM was minimal. Hence, there is a scope to reduce the AiM count.

The method 800 can continue with operation 804 with identifying systems performance criteria and prioritizing design parameters. Because AiM module count is reduced, at operation 806, performance criteria are set to achieve lower band 100-percentile EIRP and high band fifty-percentile EIRP. The lower band 100-percentile EIRP and high band fifty-percentile EIRP are of higher priority than other criteria at least because specifications defined by the 5G network providers/3GPP standard state or specify that these criteria are the most stringent to meet standards requirements. Hence, those are considered as decision making or critical criteria for determining the design parameters.

The method 800 can continue with operation 808 with prioritizing design parameters. Some design parameters include sidewall-related parameters (e.g., sidewall opening); parameters related to keep out zone (KOZ) directed to ensuring area near antennas is metal free (e.g., defining top and bottom metal KOZ); air gap parameters; radome parameters; etc. Some parameters for which Z-axis of chassis are more important have priority over other parameters. For example, size of the window opening above and below AiM, especially under dual-polarized transmission, can introduce significant reduction in gain. Hence, this parameter is fixed at operation 810. Fixing these paraments (dependent on Z-axis and sidewall opening) will enable beam steering feature with +/- 50 degrees.

Subsequently, the method can continue with operation 812 by determining the offset parameter to determine the offset parameter that gives more boresights gain towards one hemisphere by offsetting the AiM in other side. However, changing offset parameter often results in coverage being degraded. So, in most example methods no offset is chosen.

The method 800 can continue with operation 814 with fixing the gap from the AiM module to the radome (such as discussed with respect to FIG. 7A and FIG. 7B). The gap should be much less than the wavelength of both the frequencies (24 GHz, 40 GHz in the example method) to have good dual polarization transmission for a wide band performance. Aspects of the disclosure are not limited to the two frequencies shown and methods according to aspects can be implemented using or simulating more than two frequencies or other frequencies.

The method can continue with operation 816 with performing yield analysis of the radome thickness (dielectric slab), avoiding phase difference of incident waves at different angles at different frequencies (LB and HB) as discussed above with reference to FIG. 7B. Here, thinner radome (<1 mm) yields better HB peak EIRP and better MB CDF. A radome thickness should be chosen that is mechanically acceptable, for example providing sufficient protection.

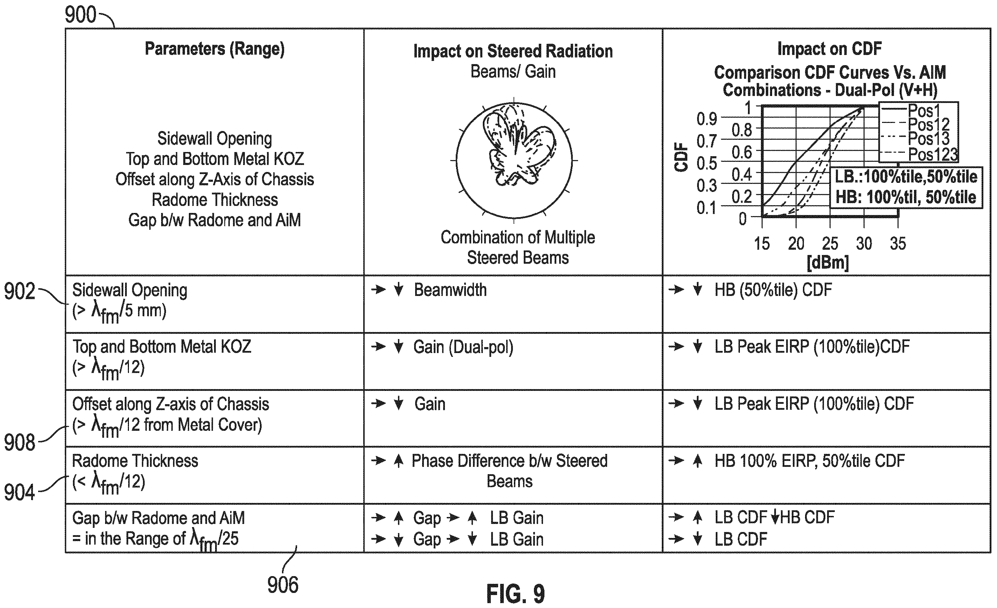

FIG. 9 illustrates correlation between different parameters 900 and impact (if violated) on the steered radiation beams or gain of the antenna. As CDF is the cumulative of the steered radiation patterns, the impact on CDF is also included. For example, when sidewall opening parameter 902 is violated, impact would be on bandwidth, which in turn affects HB CDF performance. If offset along Z-axis parameter 908 is violated, gain is impacted affecting LB performance, etc.

From FIG. 9, it can be seen that to achieve better LB 100 percentile and HB fifty percentile EIRP, radome thickness parameter 904 should (< $\lambda_{fm}$/12), which is mechanically feasible as well. Further, the sidewall window opening parameter 902 improves HB (40 GHz) fifty percentile CDF which should be > $\lambda_{fm}$/5 mm of KOZ on each side of the array of antennas. The AiM should be spaced to radome by ($\lambda_{fm}$/25, or parameter 906). Other placement or spacing parameters can be specified, e.g., offset along z-axis can be specified at parameter 908. For example, the spacing from the corner of the system (e.g., hinges) should be > 4*$\lambda_{fm}$, and a minimum of ($\lambda_{fm}$/12) spacing from metal cover is maintained to achieve the CDF specifications.

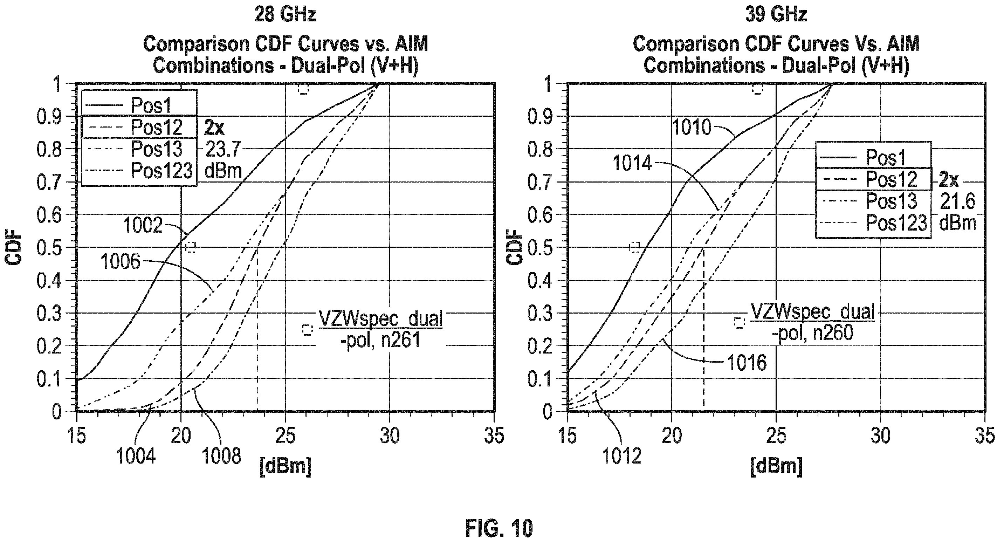

FIG. 10 illustrates CDF coverage comparison given different combinations of AiMs according to some aspects. Comparison at LB is shown on the left graph and comparison at HB is shown on the right graph. Curve 1002 illustrates LB CDF given a first AiM. Curve 1004 illustrates LB CDF given a first AiM in combination with a second AiM. Curve 1006 illustrates LB CDF given a first AiM in combination with a third AiM. Curve 1008 illustrates LB CDF given all three AiMs combined. Curve 1010 illustrates HB CDF given a first AiM. Curve 1012 illustrates HB CDF given a first AiM in combination with a second AiM. Curve 1014 illustrates HB CDF given a first AiM in combination with a third AiM. Curve 1016 illustrates HB CDF given all three AiMs combined. As can be seen, coverage can be obtained by using minimal number of AiMs in the system (e.g., two) without impacting on the any other sub-systems. A third AiM in the example does not substantially improve coverage, therefore adding a third module could impact thermals and introduce other complications without substantial benefit to laptop performance.

By implementing methods of the disclosure described above, AiM module placement can be optimized or designed to fit in thin and light fanless system without impacting on thermal! ID. Devices such as laptops with metal chasses can include sufficient antennas within a minimized or reduced number of AiM modules. By reducing number of AiM modules, the complexity of the power supply mechanism can be reduced. Some designs may include proposing side placements of AiMs, which can be used for isolating other WLAN - WWAN antennas (Wi-Fi/5G), which gives better throughput (as module size is $\lambda$/2 for high band of antenna frequencies).

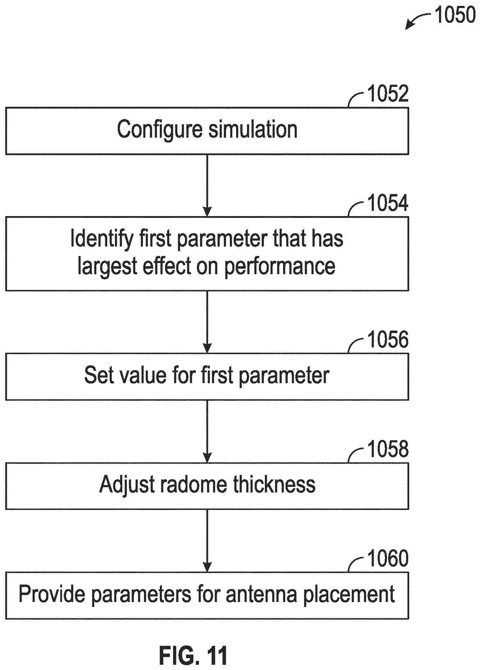

FIG. 11 illustrates a method 1050 for defining AiM parameters in accordance with some embodiments. The method 1050 can be performed using simulation software or other software similarly to that described with respect to FIG. 8 and method 800.

The method 1050 can begin with operation 1052 with configuring a simulation of antenna gain of antenna in module (AiM) components, the simulation including as an output a cumulative distribution function (CDF) representing AiM coverage.

The method 1050 can continue with operation 1054 with identifying a first parameter of a set of antenna in module (AiM) placement parameters that has a largest effect on an antenna performance criterion observed in the simulation. The first parameter can define offset, along an axis, of the AiM between a top and bottom cover of a user device. The antenna performance criterion can include a millimeter wave coverage criterion.

The method 1050 can continue with operation 1056 with setting a value for the first parameter to maintain antenna gain above a threshold in at least two frequency bands.

The method 1050 can continue with operation 1058 with adjusting radome thickness for a radome of the AiM to reduce phase difference of incident waves of AiM signals.

The method 1050 can continue with operation 1060 with providing at least the value for the first parameter and the radome thickness for placement of the AiM. The method 1050 can include setting a thickness for an air gap between the radome and the AiM to be less than any wavelengths at which the AiM is to transmit and receive signals. The thickness can be set such that a boresight error is minimized in beam steering through a desired range. The method 1050 can include providing values for parameters of a sidewall opening of a chassis of a user device.

*Remote wireless device on-off*

As described earlier herein, power consumption is also important for portable electronic devices including Internet of Things (IoT) devices in 5G Massive Machine Type Communication (mMTC). Previous solutions for IoT often included providing longer sleep cycles to reduce power consumption. However, devices still must wake periodically to check for messages from central systems, such as beacon signals, synchronization signals, etc., and therefore devices need to remain in the IDLE mode.

Aspects of this disclosure address these concerns by providing methods and circuits for remote wireless device Modem On-Off using a specific radio frequency (RF) carrier frequency (defined for each device or type of device) with existing passive circuit elements in the device for ultra-low power communication. Devices can therefore remain in a powered-down (Off) mode instead of IDLE mode. The modem for the device/s can be switched on remotely just before sending any user data / message to the device without any power consumption in the device modem for remote accessing.

By providing circuitry and implementing methods according to various aspects of the disclosure, device IDLE mode power consumption can be reduced to nearly zero. The device can nevertheless remain accessible by switching the device ON through an RF signal energy harvesting method described below. Methods according to aspects can turn on the remote communication device just before the communication starts and switches it off when communication is over for that session.

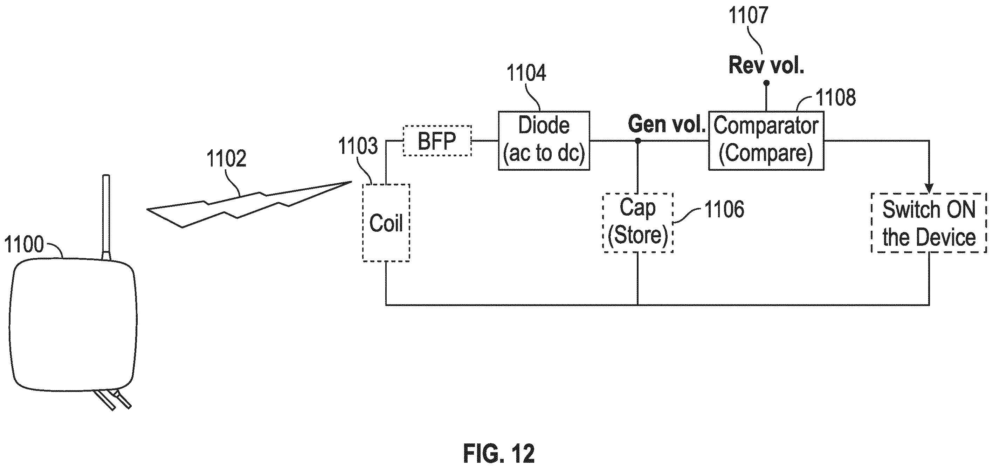

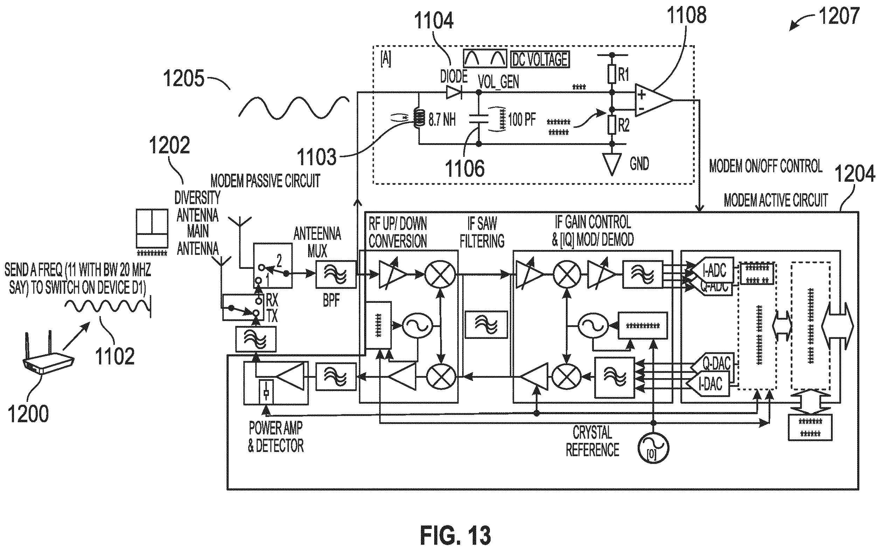

FIG. 12 is a block diagram of a solution for remote wireless device On/Off using passive circuit elements to avoid Idle mode power consumption in accordance with some aspects. FIG. 13 is a circuit diagram of an apparatus 1207 using passive circuitry 1205 of a wireless apparatus 1207 modem front-end block to implement methods in accordance with some aspects.

The modem of all devices in the network (except a primary/central device 1100) can be in the switched off state by default. Therefore, the associated devices will consume no battery power will be consumed, and no periodic activities will be performed. The associated device/s perform no dedicated send/receive activities in the modem OFF state.

Referring to FIG. 12 and FIG. 13 together, if a device 1100 modem needs to be turned on to provide a command, message or other data, a central device 1200 or other transmitting device can provide an RF signal 1102 at a predetermined or predefined center frequency (in for example a megahertz range) and with a bandwidth standard for communications in that network (for example 20 MHz as in Wi-Fi channel frequency signal).

That specific frequency RF signal 1102 can be filtered and pass via the RF front-end circuit 1202 of a communications module (e.g., Wi-Fi module) of that device. The components in circuit 1202 are passive and therefore no battery power is needed. This impinged RF A/C signal impinges on the coil 1103 (e.g., the coil acts as an antenna) and the col converts the RF signal to electrical current and voltage according to Maxwell's law). The coil 1103 can be designed to receive the specific frequency that has been predefined or predetermined for that given device.

The current is converted to D/C (unidirectional) signal by diode 1104 and the current will be used to charge a capacitor 1106 or other storage element. Once the stored charge or voltage in the capacitor 1106 becomes higher than the threshold voltage ($V_{th}$) 1107, as determined at comparator 1108, then an output of the comparator will power on the rest of the communication circuitry, e.g., the modem active circuitry 1204. In this way, any specific device can be switched On by using specific RF frequency signals. This could be used for Wi-Fi, mmWave, BT devices and could be extended for other wireless network Modems. Subsequent to being switched ON the device can commence signalling and communicating as usual for that type of device. Paging messages, etc. can be timed based on central or base station knowledge of typical power-on times for the device or type of device. The device can power back off again after, for example, a certain amount of time without uplink/downlink communications. The device can also power on without outside RF signals when the device determines communication is needed.

This circuitry can also be used for remote device search or location detection. For example, if a remote device is powered down, it can nonetheless be located and powered back on (and emitting a sound (e.g., "beep" or another signal to allow a user to locate the device) by transmitting the specific RF signal for that device.

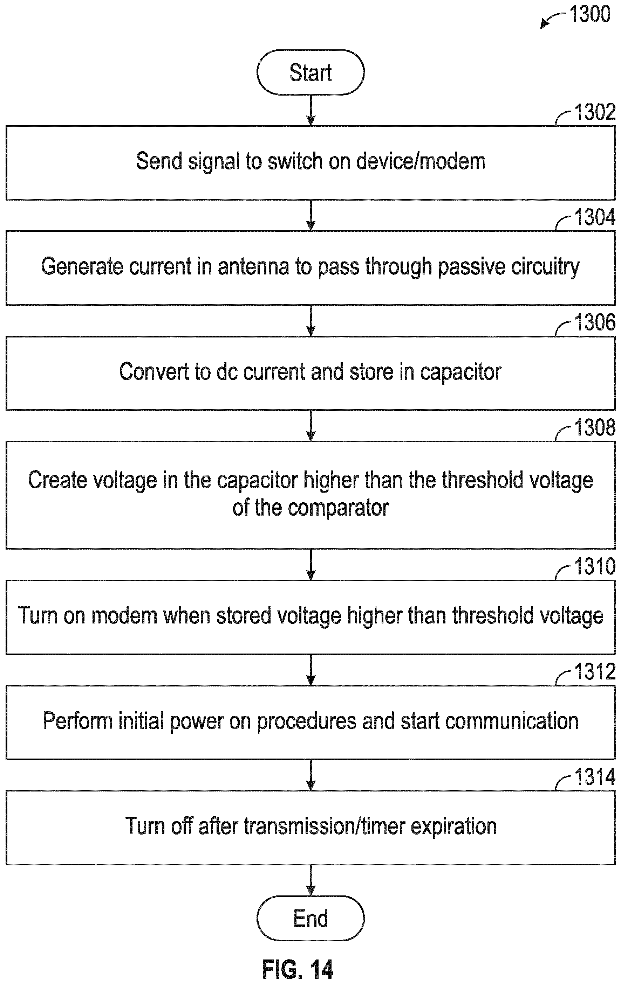

The circuitry described above can be used in implementing the method of FIG. 14. FIG. 14 illustrates a method 1300 for waking devices using passive circuitry in accordance with some aspects of the disclosure.

The method can begin with operation 1302 with a central device (e.g., apparatus 1200 (FIG. 13) providing a specific RF frequency signal to switch ON a device modem. In some examples, the signal can switch on the entire device, in addition to the modem. In operation 1304, the signal generates a current in the device antenna 1202 to pass through the passive circuitry as described above with reference to FIG. 12 and FIG. 13.

In operation 1306, a diode 1104 can convert the current to DC and voltage can be stored in a capacitive element 1106. As the RF signal is sent for some duration, this can cause charge to build up in operation 1308 until voltage is higher than a reference voltage of a comparator 1108.

In operation 1310, the device or device modem will turn on when the voltage of operation 1308 exceeds the reference volage. In operation 1312, the device will initiate startup and communication procedures according to communication standards of the device/type of device. If communications are completed or other criteria are met for power down, the modem or device may power down again in operation 1314.

IoT devices can be kept accessible at any time by maintaining the devices in IDLE even when the devices are powered off. IDLE mode communications cause devices to consume battery even when OFF. Methods according to aspects save power by turning modems completely off, so there is no power wastage in IDLE mode. Because IoT devices are in an IDLE mode for a significant amount of time, this power savings can have a large impact on power efficiency and device lifetime in many devices used in "smart" homes, factories, etc. Devices can still remain always accessible by transmitting an RF signal specific to that device to power on the modem and other active elements.

*Other systems and apparatuses*

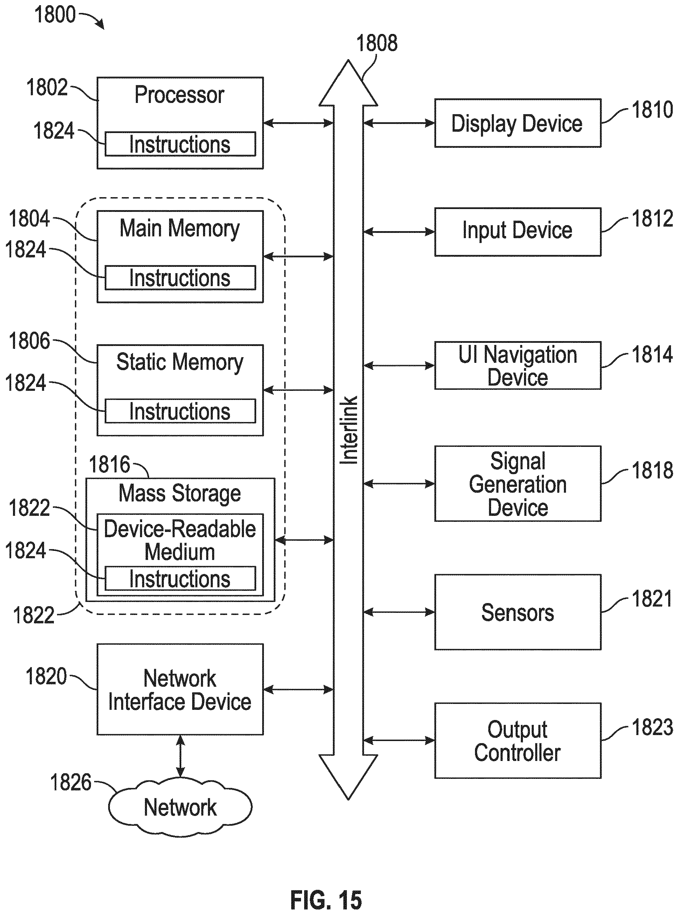

FIG. 15 illustrates a block diagram of a communication device 1800 in accordance with some aspects. In alternative aspects, the communication device 1800 may operate as a standalone device or may be connected (e.g., networked) to other communication devices. In some aspects, the communication device 1800 can use one or more of the techniques and circuits discussed herein, in connection with any of FIG. 1 - FIG. 14.

Circuitry (e.g., processing circuitry) is a collection of circuits implemented in tangible entities of the device 1800 that include hardware (e.g., simple circuits, gates, logic, etc.). Circuitry membership may be flexible over time. Circuitries include members that may, alone or in combination, perform specified operations when operating. In an example, hardware of the circuitry may be immutably designed to carry out a specific operation (e.g., hardwired). In an example, the hardware of the circuitry may include variably connected physical components (e.g., execution units, transistors, simple circuits, etc.) including a machine readable medium physically modified (e.g., magnetically, electrically, moveable placement of invariant massed particles, etc.) to encode instructions of the specific operation.

In connecting the physical components, the underlying electrical properties of a hardware constituent are changed, for example, from an insulator to a conductor or vice versa. The instructions enable embedded hardware (e.g., the execution units or a loading mechanism) to create members of the circuitry in hardware via the variable connections to carry out portions of the specific operation when in operation. Accordingly, in an example, the machine-readable medium elements are part of the circuitry or are communicatively coupled to the other components of the circuitry when the device is operating. In an example, any of the physical components may be used in more than one member of more than one circuitry. For example, under operation, execution units may be used in a first circuit of a first circuitry at one point in time and reused by a second circuit in the first circuitry, or by a third circuit in a second circuitry at a different time. Additional examples of these components with respect to the device 1800 follow.

In some aspects, the device 1800 may operate as a standalone device or may be connected (e.g., networked) to other devices. In a networked deployment, the communication device 1800 may operate in the capacity of a server communication device, a client communication device, or both in server-client network environments. In an example, the communication device 1800 may act as a peer communication device in peer-to-peer (P2P) (or other distributed) network environment. The communication device 1800 may be a UE, eNB, PC, a tablet PC, a STB, a PDA, a mobile telephone, a smart phone, a web appliance, a network router, switch or bridge, or any communication device capable of executing instructions (sequential or otherwise) that specify actions to be taken by that communication device. Further, while only a single communication device is illustrated, the term "communication device" shall also be taken to include any collection of communication devices that individually or jointly execute a set (or multiple sets) of instructions to perform any one or more of the methodologies discussed herein, such as cloud computing, software as a service (SaaS), other computer cluster configurations.

Examples, as described herein, may include, or may operate on, logic or a number of components, modules, or mechanisms. Modules are tangible entities (e.g., hardware) capable of performing specified operations and may be configured or arranged in a certain manner. In an example, circuits may be arranged (e.g., internally or with respect to external entities such as other circuits) in a specified manner as a module. In an example, the whole or part of one or more computer systems (e.g., a standalone, client or server computer system) or one or more hardware processors may be configured by firmware or software (e.g., instructions, an application portion, or an application) as a module that operates to perform specified operations. In an example, the software may reside on a communication device-readable medium. In an example, the software, when executed by the underlying hardware of the module, causes the hardware to perform the specified operations.

Accordingly, the term "module" is understood to encompass a tangible entity, be that an entity that is physically constructed, specifically configured (e.g., hardwired), or temporarily (e.g., transitorily) configured (e.g., programmed) to operate in a specified manner or to perform part or all of any operation described herein. Considering examples in which modules are temporarily configured, each of the modules need not be instantiated at any one moment in time. For example, where the modules comprise a general-purpose hardware processor configured using software, the general-purpose hardware processor may be configured as respective different modules at different times. Software may accordingly configure a hardware processor, for example, to constitute a particular module at one instance of time and to constitute a different module at a different instance of time.

Communication device (e.g., UE) 1800 may include a hardware processor 1802 (e.g., a central processing unit (CPU), a graphics processing unit (GPU), a hardware processor core, or any combination thereof), a main memory 1804, a static memory 1806, and mass storage 1816 (e.g., hard drive, tape drive, flash storage, or other block or storage devices), some or all of which may communicate with each other via an interlink (e.g., bus) 1808.

The communication device 1800 may further include a display unit 1810, an alphanumeric input device 1812 (e.g., a keyboard), and a user interface (UI) navigation device 1814 (e.g., a mouse). In an example, the display unit 1810, input device 1812 and UI navigation device 1814 may be a touch screen display. The communication device 1800 may additionally include a signal generation device 1818 (e.g., a speaker), a network interface device 1820, and one or more sensors 1821, such as a global positioning system (GPS) sensor, compass, accelerometer, or another sensor. The communication device 1800 may include an output controller 1823, such as a serial (e.g., universal serial bus (USB), parallel, or other wired or wireless (e.g., infrared (IR), near field communication (NFC), etc.) connection to communicate or control one or more peripheral devices (e.g., a printer, card reader, etc.).

The mass storage 1816 may include a communication device-readable medium 1822, on which is stored one or more sets of data structures or instructions 1824 (e.g., software) embodying or utilized by any one or more of the techniques or functions described herein. In some aspects, registers of the processor 1802, the main memory 1804, the static memory 1806, and/or the mass storage 1816 may be, or include (completely or at least partially), the device-readable medium 1822, on which is stored the one or more sets of data structures or instructions 1824, embodying or utilized by any one or more of the techniques or functions described herein. In an example, one or any combination of the hardware processor 1802, the main memory 1804, the static memory 1806, or the mass storage 1816 may constitute the device-readable medium 1822.

As used herein, the term "device-readable medium" is interchangeable with "computer-readable medium" or "machine-readable medium". While the communication device-readable medium 1822 is illustrated as a single medium, the term "communication device-readable medium" may include a single medium or multiple media (e.g., a centralized or distributed database, and/or associated caches and servers) configured to store the one or more instructions 1824.

The term "communication device-readable medium" may include any medium that is capable of storing, encoding, or carrying instructions for execution by the communication device 1800 and that cause the communication device 1800 to perform any one or more of the techniques of the present disclosure, or that is capable of storing, encoding or carrying data structures used by or associated with such instructions. Non-limiting communication device-readable medium examples may include solid-state memories, and optical and magnetic media. Specific examples of communication device-readable media may include: non-volatile memory, such as semiconductor memory devices (e.g., Electrically Programmable Read-Only Memory (EPROM), Electrically Erasable Programmable Read-Only Memory (EEPROM)) and flash memory devices; magnetic disks, such as internal hard disks and removable disks; magneto-optical disks; Random Access Memory (RAM); and CD-ROM and DVD-ROM disks. In some examples, communication device-readable media may include non-transitory communication device-readable media. In some examples, communication device-readable media may include communication device-readable media that is not a transitory propagating signal.

The instructions 1824 may further be transmitted or received over a communications network 1826 using a transmission medium via the network interface device 1820 utilizing any one of a number of transfer protocols (e.g., frame relay, internet protocol (IP), transmission control protocol (TCP), user datagram protocol (UDP), hypertext transfer protocol (HTTP), etc.). Example communication networks may include a local area network (LAN), a wide area network (WAN), a packet data network (e.g., the Internet), mobile telephone networks (e.g., cellular networks), Plain Old Telephone (POTS) networks, and wireless data networks (e.g., Institute of Electrical and Electronics Engineers (IEEE) 802.11 family of standards known as Wi-Fi®, IEEE 802.16 family of standards known as WiMax®), IEEE 802.15.4 family of standards, a Long Term Evolution (LTE) family of standards, a Universal Mobile Telecommunications System (UMTS) family of standards, peer-to-peer (P2P) networks, among others. In an example, the network interface device 1820 may include one or more physical jacks (e.g., Ethernet, coaxial, or phone jacks) or one or more antennas to connect to the communications network 1826. In an example, the network interface device 1820 may include a plurality of antennas to wirelessly communicate using at least one of single-input multiple-output (SIMO), MIMO, or multiple-input single-output (MISO) techniques. In some examples, the network interface device 1820 may wirelessly communicate using Multiple User MIMO techniques.

The term "transmission medium" shall be taken to include any intangible medium that is capable of storing, encoding, or carrying instructions for execution by the communication device 1800, and includes digital or analog communications signals or other intangible medium to facilitate communication of such software. In this regard, a transmission medium in the context of this disclosure is a device-readable medium.

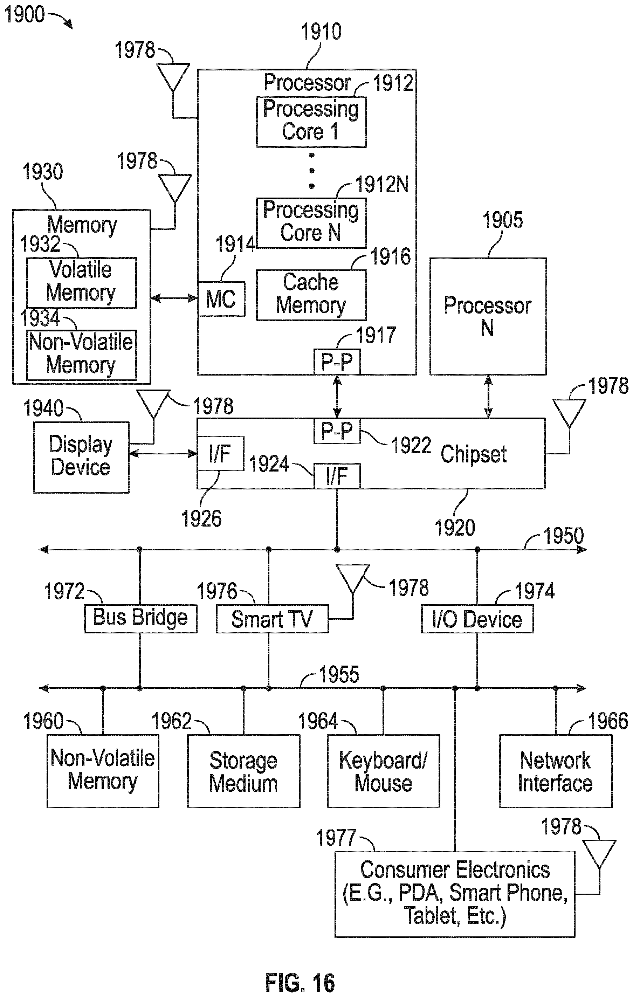

FIG. 16 illustrates a system level diagram, depicting an example of an electronic device (e.g., system) that can include, for example, a transmitter configured to selectively fan out a signal to one of multiple communication channels. FIG. 16 is included to show an example of a higher-level device application for the subject matter discussed above with regards to FIGS. 1-15. In one aspect, system 1900 includes, but is not limited to, a desktop computer, a laptop computer, a netbook, a tablet, a notebook computer, a personal digital assistant (PDA), a server, a workstation, a cellular telephone, a mobile computing device, a smart phone, an Internet appliance, or any other type of computing device. In some aspects, system 1900 is a system on a chip (SOC) system.

In one aspect, processor 1910 has one or more processor cores 1912, ..., 1912N, where 1912N represents the Nth processor core inside processor 1910 where N is a positive integer. In one aspect, system 1900 includes multiple processors including 1910 and 1905, where processor 1905 has logic similar or identical to the logic of processor 1910. In some aspects, processing core 1912 includes, but is not limited to, pre-fetch logic to fetch instructions, decode logic to decode the instructions, execution logic to execute instructions and the like. In some aspects, processor 1910 has a cache memory 1916 to cache instructions and/or data for system 1900. Cache memory 1916 may be organized into a hierarchal structure including one or more levels of cache memory.

In some aspects, processor 1910 includes a memory controller 1914, which is operable to perform functions that enable the processor 1910 to access and communicate with memory 1930 that includes a volatile memory 1932 and/or a non-volatile memory 1934. In some aspects, processor 1910 is coupled with memory 1930 and chipset 1920. Processor 1910 may also be coupled to a wireless antenna 1978 to communicate with any device configured to transmit and/or receive wireless signals. In one aspect, an interface for wireless antenna 1978 operates in accordance with, but is not limited to, the IEEE 802.11 standard and its related family, Home Plug AV (HPAV), Ultra-Wide Band (UWB), Bluetooth, WiMax, or any form of wireless communication protocol.

In some aspects, volatile memory 1932 includes, but is not limited to, Synchronous Dynamic Random Access Memory (SDRAM), Dynamic Random Access Memory (DRAM), RAMBUS Dynamic Random Access Memory (RDRAM), and/or any other type of random-access memory device. Non-volatile memory 1934 includes, but is not limited to, flash memory, phase change memory (PCM), read-only memory (ROM), electrically erasable programmable read-only memory (EEPROM), or any other type of non-volatile memory device.

Memory 1930 stores information and instructions to be executed by processor 1910. In one aspect, memory 1930 may also store temporary variables or other intermediate information while processor 1910 is executing instructions. In the illustrated aspect, chipset 1920 connects with processor 1910 via Point-to-Point (PtP or P-P) interfaces 1917 and 1922. Chipset 1920 enables processor 1910 to connect to other elements in system 1900. In some aspects of the example system, interfaces 1917 and 1922 operate in accordance with a PtP communication protocol such as the Intel® Quick-Path Interconnect (QPI) or the like. In other aspects, a different interconnect may be used.

In some aspects, chipset 1920 is operable to communicate with processor 1910, 1905, display device 1940, and other devices, including a bus bridge 1972, a smart TV 1976, I/O devices 1974, nonvolatile memory 1960, a storage medium (such as one or more mass storage devices) 1962, a keyboard/mouse 1964, a network interface 1966, and various forms of consumer electronics 1977 (such as a PDA, smart phone, tablet etc.), etc. In one aspect, chipset 1920 couples with these devices through an interface 1924. Chipset 1920 may also be coupled to a wireless antenna 1978 to communicate with any device configured to transmit and/or receive wireless signals.

Chipset 1920 connects to display device 1940 via interface 1926. Display device 1940 may be, for example, a liquid crystal display (LCD), a plasma display, cathode ray tube (CRT) display, or any other form of visual display device. In some aspects of the example system, processor 1910 and chipset 1920 are merged into a single SOC. In addition, chipset 1920 connects to one or more buses 1950 and 1955 that interconnect various system elements, such as I/O devices 1974, nonvolatile memory 1960, storage medium 1962, a keyboard/mouse 1964, and network interface 1966. Buses 1950 and 1955 may be interconnected together via a bus bridge 1972.

In one aspect, storage medium 1962 includes, but is not limited to, a solid-state drive, a hard disk drive, a universal serial bus flash memory drive, or any other form of computer data storage medium. In one aspect, network interface 1966 is implemented by any type of well-known network interface standard including, but not limited to, an Ethernet interface, a universal serial bus (USB) interface, a Peripheral Component Interconnect (PCI) Express interface, a wireless interface and/or any other suitable type of interface. In one aspect, the wireless interface operates in accordance with, but is not limited to, the IEEE 802.11 standard and its related family, Home Plug AV (HPAV), Ultra-Wide Band (UWB), Bluetooth, WiMax, or any form of wireless communication protocol.

While the modules shown in FIG. 15 are depicted as separate blocks within the system 1900, the functions performed by some of these blocks may be integrated within a single semiconductor circuit or may be implemented using two or more separate integrated circuits. For example, although cache memory 1916 is depicted as a separate block within processor 1910, cache memory 1916 (or selected aspects of 1916) can be incorporated into processor core 1912.

Discussions herein utilizing terms such as, for example, "processing", "computing", "calculating", "determining", "establishing", "analyzing", "checking", or the like, may refer to operation(s) and/or process(es) of a computer, a computing platform, a computing system, or other electronic computing device, that manipulate and/or transform data represented as physical (e.g., electronic) quantities within the computer's registers and/or memories into other data similarly represented as physical quantities within the computer's registers and/or memories or other information storage medium that may store instructions to perform operations and/or processes.

The terms "plurality" and "a plurality", as used herein, include, for example, "multiple" or "two or more". For example, "a plurality of items" includes two or more items.

References to "one aspect", "an aspect", "an example aspect", "some aspects", "demonstrative aspect", "various aspects" etc., indicate that the aspect(s) so described may include a particular feature, structure, or characteristic, but not every aspect necessarily includes the particular feature, structure, or characteristic. Further, repeated use of the phrase "in one aspect" does not necessarily refer to the same aspect, although it may.

As used herein, unless otherwise specified the use of the ordinal adjectives "first", "second", "third" etc., to describe a common object, merely indicate that different instances of like objects are being referred to and are not intended to imply that the objects so described must be in a given sequence, either temporally, spatially, in ranking, or in any other manner.

Some aspects may be used in conjunction with various devices and systems, for example, a User Equipment (UE), a Mobile Device (MD), a wireless station (STA), a Personal Computer (PC), a desktop computer, a mobile computer, a laptop computer, a notebook computer, a tablet computer, a server computer, a handheld computer, a sensor device, an Internet of Things (IoT) device, a wearable device, a handheld device, a Personal Digital Assistant (PDA) device, a handheld PDA device, an on-board device, an off-board device, a hybrid device, a vehicular device, a non-vehicular device, a mobile or portable device, a consumer device, a non-mobile or non-portable device, a wireless communication station, a wireless communication device, a wireless Access Point (AP), a wired or wireless router, a wired or wireless modem, a video device, an audio device, an audio-video (A/V) device, a wired or wireless network, a wireless area network, a Wireless Video Area Network (WVAN), a Local Area Network (LAN), a Wireless LAN (WLAN), a Personal Area Network (PAN), a Wireless PAN (WPAN), and the like.

Some aspects may, for example, be used in conjunction with devices and/or networks operating in accordance with existing IEEE 802.11 standards (including IEEE 802.11-2016 (IEEE 802.11-2016, IEEE Standard for Information technology-Telecommunications and information exchange between systems Local and metropolitan area networks--Specific requirements Part 11: Wireless LAN Medium Access Control (MAC) and Physical Layer (PHY) Specifications, December 7, 2016); IEEE 802.11ay (P802.11ay Standard for Information Technology--Telecommunications and Information Exchange Between Systems Local and Metropolitan Area Networks--Specific Requirements Part 11: Wireless LAN Medium Access Control (MAC) and Physical Layer (PHY) SpecificationsAmendment: Enhanced Throughput for Operation in License-Exempt Bands Above 45 GHz)) and/or future versions and/or derivatives thereof, devices and/or networks operating in accordance with existing WiFi Alliance (WFA) Peer-to-Peer (P2P) specifications (including WiFi P2P technical specification, version 1.5, August 4, 2015) and/or future versions and/or derivatives thereof, devices and/or networks operating in accordance with existing Wireless-Gigabit-Alliance (WGA) specifications (including Wireless Gigabit Alliance, Inc WiGig MAC and PHY Specification Version 1.1, April 2011, Final specification) and/or future versions and/or derivatives thereof, devices and/or networks operating in accordance with existing cellular specifications and/or protocols, e.g., 3rd Generation Partnership Project (3GPP), 3GPP Long Term Evolution (LTE) and/or future versions and/or derivatives thereof, units and/or devices which are part of the above networks, and the like.

Some aspects may be used in conjunction with one way and/or two-way radio communication systems, cellular radio-telephone communication systems, a mobile phone, a cellular telephone, a wireless telephone, a Personal Communication Systems (PCS) device, a PDA device which incorporates a wireless communication device, a mobile or portable Global Positioning System (GPS) device, a device which incorporates a GPS receiver or transceiver or chip, a device which incorporates an RFID element or chip, a Multiple Input Multiple Output (MIMO) transceiver or device, a Single Input Multiple Output (SIMO) transceiver or device, a Multiple Input Single Output (MISO) transceiver or device, a device having one or more internal antennas and/or external antennas, Digital Video Broadcast (DVB) devices or systems, multi-standard radio devices or systems, a wired or wireless handheld device, e.g., a Smartphone, a Wireless Application Protocol (WAP) device, or the like.

Some aspects may be used in conjunction with one or more types of wireless communication signals and/or systems, for example, Radio Frequency (RF), Infra-Red (IR), Frequency-Division Multiplexing (FDM), Orthogonal FDM (OFDM), Orthogonal Frequency-Division Multiple Access (OFDMA), Spatial Divisional Multiple Access (SDMA), FDM Time-Division Multiplexing (TDM), Time-Division Multiple Access (TDMA), Multi-User MIMO (MU-MIMO), Extended TDMA (E-TDMA), General Packet Radio Service (GPRS), extended GPRS, Code-Division Multiple Access (CDMA), Wideband CDMA (WCDMA), CDMA 2000, single-carrier CDMA, multi-carrier CDMA, Multi-Carrier Modulation (MDM), Discrete Multi-Tone (DMT), Bluetooth, Global Positioning System (GPS), Wi-Fi, Wi-Max, ZigBeeTM, Ultra-Wideband (UWB), Global System for Mobile communication (GSM), 2G, 2.5G, 3G, 3.5G, 4G, Fifth Generation (5G) mobile networks, 3GPP, Long Term Evolution (LTE), LTE advanced, Enhanced Data rates for GSM Evolution (EDGE), or the like. Other aspects may be used in various other devices, systems and/or networks.

The term "wireless device", as used herein, includes, for example, a device capable of wireless communication, a communication device capable of wireless communication, a communication station capable of wireless communication, a portable or non-portable device capable of wireless communication, or the like. In some demonstrative aspects, a wireless device may be or may include a peripheral that is integrated with a computer, or a peripheral that is attached to a computer. In some demonstrative aspects, the term "wireless device" may optionally include a wireless service.

The term "communicating" as used herein with respect to a communication signal includes transmitting the communication signal and/or receiving the communication signal. For example, a communication unit, which is capable of communicating a communication signal, may include a transmitter to transmit the communication signal to at least one other communication unit, and/or a communication receiver to receive the communication signal from at least one other communication unit. The verb communicating may be used to refer to the action of transmitting and/or the action of receiving. In one example, the phrase "communicating a signal" may refer to the action of transmitting the signal by a first device and may not necessarily include the action of receiving the signal by a second device. In another example, the phrase "communicating a signal" may refer to the action of receiving the signal by a first device and may not necessarily include the action of transmitting the signal by a second device.

Some demonstrative aspects may be used in conjunction with a wireless communication network communicating over a frequency band above 45 Gigahertz (GHz), e.g., 60 GHz. However, other aspects may be implemented utilizing any other suitable wireless communication frequency bands, for example, an Extremely High Frequency (EHF) band (the millimeter wave (mmWave) frequency band), e.g., a frequency band within the frequency band of between 20 GHz and 300 GHz, a frequency band above 45 GHz, a frequency band below 20 GHz, e.g., a Sub 1 GHz (S1G) band, a 2.4 GHz band, a 5 GHz band, a WLAN frequency band, a WPAN frequency band, a frequency band according to the WGA specification, and the like.

As used herein, the term "circuitry" may, for example, refer to, be part of, or include, an Application Specific Integrated Circuit (ASIC), an integrated circuit, an electronic circuit, a processor (shared, dedicated, or group), and/or memory (shared, dedicated, or group), that execute one or more software or firmware programs, a combinational logic circuit, and/or other suitable hardware components that provide the described functionality. In some aspects, circuitry may include logic, at least partially operable in hardware. In some aspects, the circuitry may be implemented as part of and/or in the form of a radio virtual machine (RVM), for example, as part of a Radio processor (RP) configured to execute code to configured one or more operations and/or functionalities of one or more radio components.

The term "logic" may refer, for example, to computing logic embedded in circuitry of a computing apparatus and/or computing logic stored in a memory of a computing apparatus. For example, the logic may be accessible by a processor of the computing apparatus to execute the computing logic to perform computing functions and/or operations. In one example, logic may be embedded in various types of memory and/or firmware, e.g., silicon blocks of various chips and/or processors. Logic may be included in, and/or implemented as part of, various circuitry, e.g., radio circuitry, receiver circuitry, control circuitry, transmitter circuitry, transceiver circuitry, processor circuitry, and/or the like. In one example, logic may be embedded in volatile memory and/or non-volatile memory, including random access memory, read only memory, programmable memory, magnetic memory, flash memory, persistent memory, and/or the like. Logic may be executed by one or more processors using memory, e.g., registers, buffers, stacks, and the like, coupled to the one or more processors, e.g., as necessary to execute the logic.

The term "antenna" or "antenna array", as used herein, may include any suitable configuration, structure and/or arrangement of one or more antenna elements, components, units, assemblies and/or arrays. In some aspects, the antenna may implement transmit and receive functionalities using separate transmit and receive antenna elements. In some aspects, the antenna may implement transmit and receive functionalities using common and/or integrated transmit/receive elements. The antenna may include, for example, a phased array antenna, a single element antenna, a set of switched beam antennas, and/or the like.

## ADDITIONAL NOTES AND ASPECTS

Example 1 is a computer-readable medium including instructions, that, when executed on simulator circuitry, cause the simulator circuitry to perform operations including: configuring a simulation of antenna gain of antenna in module (AiM) components, the simulation including as an output a cumulative distribution function (CDF) representing AiM coverage; identifying a first parameter of a set of antenna in module (AiM) placement parameters that has a largest effect on an antenna performance criterion observed in the simulation; setting a value for the first parameter to maintain antenna gain above a threshold in at least two frequency bands; adjusting radome thickness for a radome of the AiM to reduce phase difference of incident waves of AiM signals; and providing at least the value for the first parameter and the radome thickness for placement of the AiM.

In Example 2, the subject matter of Example 1 can optionally include wherein the first parameter defines offset, along an axis, of the AiM between a top and bottom cover of a user device.

In Example 3, the subject matter of Example 2 can optionally include wherein the operations further comprise: setting a thickness for an air gap between the radome and the AiM to be less than any wavelengths at which the AiM is to transmit and receive signals.

In Example 4, the subject matter of Example 3 can optionally include wherein the thickness is set such that a boresight error is minimized in beam steering through a desired range.

In Example 5, the subject matter of any of Examples 1-4 can optionally include wherein the operations further comprise: providing values for parameters of a sidewall opening of a chassis of a user device.

In Example 6, the subject matter of any of Examples 1-5 can optionally include wherein antenna performance criterion include a millimeter wave coverage criterion.

In Example 7, the subject matter of any of Examples 1-6 can optionally include operating the AiM in at least one millimeter wave frequency band.

Example 8 is a method for performing any of Examples 1-7.

Example 9 is a system comprising means for performing any of Examples 1-7.

In Example 10, an apparatus can comprise at least one antenna; and a radio frequency front end module (RFEM) coupled to the at least one antenna, the RFEM including: active circuitry and passive circuitry, the passive circuitry to be energized by a signal at a center frequency for the apparatus, wherein the passive circuitry is configured to: store electrical charge upon reception of the signal at the center frequency, and provide power to wake active circuitry upon stored charge reaching or exceeding a threshold charge.

In Example 11, the subject matter of Example 10 can optionally include wherein the passive circuitry includes a band pass filter configured to pass frequencies within a bandwidth of the center frequency for the apparatus.

In Example 12, the subject matter of Example 11 can optionally include wherein the passive circuitry includes a diode to convert the signal to direct current and a capacitive element to store the charge.

In Example 13, the subject matter of Example 12 can optionally include wherein the passive circuitry includes a comparator configured to provide the signal to wake active circuitry upon stored charge reaching or exceeding a threshold charge.

In Example 14, the subject matter of Example 13 can optionally include wherein the passive circuitry is further configured to remotely power a modem component upon providing the signal to wake.

In Example 15 the subject matter of Example 13 can optionally include wherein the passive circuitry is further configured to remotely power the apparatus upon providing the signal to wake.

In Example 16, the subject matter of any of Examples 10-15 can optionally include wherein the active circuitry is configured to power down a modem component at a time period subsequent to powering up.

Example 17 is a system comprising means to perform any of Examples 10-16.

Example 18 is a method including operations to perform any of Examples 10-16.

The above detailed description includes references to the accompanying drawings, which form a part of the detailed description. The drawings show, by way of illustration, specific aspects in which the invention can be practiced. These aspects are also referred to herein as "examples." Such examples can include elements in addition to those shown or described. However, the present inventors also contemplate examples in which only those elements shown or described are provided. Moreover, the present inventors also contemplate examples using any combination or permutation of those elements shown or described (or one or more aspects thereof), either with respect to a particular example (or one or more aspects thereof), or with respect to other examples (or one or more aspects thereof) shown or described herein.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In this document, the terms "including" and "in which" are used as the plain-English equivalents of the respective terms "comprising" and "wherein." Also, in the following claims, the terms "including" and "comprising" are open-ended, that is, a system, device, article, composition, formulation, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects.

The above description is intended to be illustrative, and not restrictive. For example, the above-described examples (or one or more aspects thereof) may be used in combination with each other. Other aspects can be used, such as by one of ordinary skill in the art upon reviewing the above description. The Abstract is provided to allow the reader to quickly ascertain the nature of the technical disclosure. It is submitted with the understanding that it will not be used to interpret or limit the scope or meaning of the claims. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed aspect. Thus, the following claims are hereby incorporated into the Detailed Description, with each claim standing on its own as a separate aspect, and it is contemplated that such aspects can be combined with each other in various combinations or permutations. The scope of the invention should be determined with reference to the appended claims, along with the full scope of equivalents to which such claims are legally entitled.

**Claims**

1. A computer-readable medium including instructions, that, when executed on simulator circuitry, cause the simulator circuitry to perform operations including:

   configuring a simulation of antenna gain of antenna in module (AiM) components, the simulation including as an output a cumulative distribution function (CDF) representing AiM coverage;
   identifying a first parameter of a set of antenna in module (AiM) placement parameters that has a largest effect on an antenna performance criterion observed in the simulation;
   setting a value for the first parameter to maintain antenna gain above a threshold in at least two frequency bands;
   adjusting radome thickness for a radome of the AiM to reduce phase difference of incident waves of AiM signals; and
   providing at least the value for the first parameter and the radome thickness for placement of the AiM.

2. The computer-readable medium of claim 1, wherein the first parameter defines offset, along an axis, of the AiM between a top and bottom cover of a user device.

3. The computer-readable medium of claim 2, wherein the operations further comprise:
   setting a thickness for an air gap between the radome and the AiM to be less than any wavelengths at which the AiM is to transmit and receive signals.

4. The computer-readable medium of claim 3, wherein the thickness is set such that a boresight error is minimized in beam steering through a desired range.

5. The computer-readable medium of any one of claims 1-4, wherein the operations further comprise: providing values for parameters of a sidewall opening of a chassis of a user device.

6. The computer-readable medium of any one of claims 1-5, wherein antenna performance criterion include a millimeter wave coverage criterion.

7. The computer-readable medium of any one of claims 1-6, wherein the operations further include:
   operating the AiM in at least one millimeter wave frequency band.

8. A method for defining antenna in module (AiM) placement within a user device, the method comprising:

   configuring a simulation of antenna gain of antenna in module (AiM) components, the simulation including as an output a cumulative distribution function (CDF) representing AiM coverage;
   identifying a first parameter of a set of antenna in module (AiM) placement parameters that has a largest effect on an antenna performance criterion observed in the simulation;
   setting a value for the first parameter to maintain antenna gain above a threshold in at least two frequency bands;
   adjusting radome thickness for a radome of the AiM to reduce phase difference of incident waves of AiM signals; and
   providing at least the value for the first parameter and the radome thickness for placement of the AiM.

9. The method of claim 8, wherein the first parameter defines offset, along an axis, of the AiM between a top and bottom cover of the user device.

**10.** The method of claim 9, further comprising: setting a thickness for an air gap between the radome and the AiM to be less than any wavelengths at which the AiM is to transmit and receive signals.

**11.** The method of claim 10, wherein the thickness is set such that a boresight error is minimized in beam steering through a desired range.

**12.** The method of any one of claims 8-11, further comprising: providing values for parameters of a sidewall opening of a chassis of the user device.

**13.** The method of any one of claims 8-12, wherein antenna performance criterion includes a millimeter wave coverage criterion.

**14.** Machine-readable storage, including machine-readable instructions, which, when executed, cause a computer to implement a method as claimed in any preceding claim.

**15.** A computer program comprising instructions which, when the program is executed by a computer, cause the computer to carry out a method as claimed in any preceding claim.

FIG. 1

FIG. 1A

300

Protocol Processing Circuitry — 305

Digital Baseband Circuitry — 310

Transmit Circuitry — 315

Receive Circuitry — 320

Radio Frequency Circuitry — 325

Antenna Array — 330

**FIG. 2A**

**FIG. 2B**

**FIG. 2C**

**FIG. 2D**

FIG. 2E

425

430

424

Filtering &
Amplification
Circuitry

Power Combining & Dividing
Circuitry

Radio Chain
Circuitry

Radio Chain
Circuitry

415

410

Filtering
Circuitry

Up-
Conversion
/Down-
Conversion
Circuitry

435

Radio Chain
Circuitry

405

IF Interface
Circuitry

Synthesizer
Circuitry

420

**FIG. 3**

500

510

mmW (>6 GHz)
RFEM

520

515

>6 GHz
RFIC

>6 GHz
RFIC

525

535

540

>6 GHz + <6 GHz
RFEM

530

**FIG. 4A**

**FIG. 4B**

**FIG. 5A**

**FIG. 5B**

FIG. 6

EP 4 579 949 A1

**FIG. 6A**

**FIG. 6B**

+ 50 degree

Radome
Dielectric
$\varepsilon_8 \sim 3$  704

Gap
Air
$\varepsilon_8 \sim 1$

702

700

AiM

706

Propagation
direction

- 50 degree

FIG. 7A

**ABS Material C₃ ~ 3 thickness ~ 1 mm**

FIG. 7B

800

802
Observe contribution from individual AiM placements

804
Identify criteria

806
Set parameters to maintain antenna gain above threshold

808
Prioritize key design parameters:

810
Set value for first parameter

812
Set offset along Z-axis

814
Fix gap

816
Perform yield analysis of radome thickness to avoid phase difference of incident waves

FIG. 8

900

| Parameters (Range) | Impact on Steered Radiation Beams/ Gain | Impact on CDF |
|---|---|---|
| Sidewall Opening<br>Top and Bottom Metal KOZ<br>Offset along Z-Axis of Chassis<br>Radome Thickness<br>Gap b/w Radome and AiM | <br>Combination of Multiple Steered Beams | Comparison CDF Curves Vs. AiM Combinations - Dual-Pol (V+H)<br><br>LB.:100%tile,50%tile<br>HB: 100%til, 50%tile |
| Sidewall Opening<br>(> $\lambda_{fm}$/5 mm) | → ↓ Beamwidth | → ↓ HB (50%tile) CDF |
| Top and Bottom Metal KOZ<br>(> $\lambda_{fm}$/12) | → ↓ Gain (Dual-pol) | → ↓ LB Peak EIRP (100%tile)CDF |
| Offset along Z-axis of Chassis<br>(> $\lambda_{fm}$/12 from Metal Cover) | → ↓ Gain | → ↓ LB Peak EIRP (100%tile) CDF |
| Radome Thickness<br>(< $\lambda_{fm}$/12) | → ↑ Phase Difference b/w Steered Beams | → ↑ HB 100% EIRP, 50%tile CDF |
| Gap b/w Radome and AiM<br>= in the Range of $\lambda_{fm}$/25 | → ↑ Gap → ↑ LB Gain<br>→ ↓ Gap → ↓ LB Gain | → ↑ LB CDF ↓HB CDF<br>→ ↓ LB CDF |

902  908  904  906

**FIG. 9**

EP 4 579 949 A1

**FIG. 10**

EP 4 579 949 A1

1050

1052

Configure simulation

1054

Identify first parameter that has
largest effect on performance

1056

Set value for first parameter

1058

Adjust radome thickness

1060

Provide parameters for antenna placement

**FIG. 11**

FIG. 12

**FIG. 13**

EP 4 579 949 A1

1300

Start

1302

Send signal to switch on device/modem

1304

Generate current in antenna to pass through passive circuitry

1306

Convert to dc current and store in capacitor

1308

Create voltage in the capacitor higher than the threshold voltage of the comparator

1310

Turn on modem when stored voltage higher than threshold voltage

1312

Perform initial power on procedures and start communication

1314

Turn off after transmission/timer expiration

End

FIG. 14

**FIG. 15**

**FIG. 16**

## EUROPEAN SEARCH REPORT

**Application Number**

EP 24 21 6193

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | ARNAUD L AMADJIKPE ET AL: "Location Specific Coverage With Wireless Platform Integrated 60-GHz Antenna Systems", IEEE TRANSACTIONS ON ANTENNAS AND PROPAGATION, IEEE, USA, vol. 59, no. 7, 1 July 2011 (2011-07-01), pages 2661-2671, XP011369365, ISSN: 0018-926X, DOI: 10.1109/TAP.2011.2152330 | 1-4, 6-11, 13-15 | INV. H01Q1/22 H01Q1/42 H01Q3/34 H01Q5/307 ADD. H01Q1/02 |
| A | * pages 1-11; figures 1-14 * | 5,12 | |
| Y | US 2020/212569 A1 (KUMAR JEONG IL JAY [US] ET AL) 2 July 2020 (2020-07-02) * paragraphs [0001] - [0085]; figures 1-15 * | 1-4, 6-11, 13-15 | |
| A | US 2016/344095 A1 (TAGI HIROYOSHI [JP]) 24 November 2016 (2016-11-24) * paragraphs [0001] - [0112]; figures 1-10 * | 1-15 | |

**TECHNICAL FIELDS SEARCHED (IPC)**

H01Q

The present search report has been drawn up for all claims

| Place of search | Date of completion of the search | Examiner |
|---|---|---|
| The Hague | 24 April 2025 | El-Shaarawy, Heba |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 24 21 6193

This annex lists the patent family members relating to the patent documents cited in the above-mentioned European search report.
The members are as contained in the European Patent Office EDP file on
The European Patent Office is in no way liable for these particulars which are merely given for the purpose of information.

24-04-2025

| Patent document cited in search report | Publication date | Patent family member(s) | | Publication date |
|---|---|---|---|---|
| US 2020212569 A1 | 02-07-2020 | US | 2020212569 A1 | 02-07-2020 |
| | | US | 2022278452 A1 | 01-09-2022 |
| | | WO | 2020140019 A1 | 02-07-2020 |
| US 2016344095 A1 | 24-11-2016 | CN | 106169652 A | 30-11-2016 |
| | | EP | 3096400 A1 | 23-11-2016 |
| | | JP | 6440123 B2 | 19-12-2018 |
| | | JP | 2016219996 A | 22-12-2016 |
| | | US | 2016344095 A1 | 24-11-2016 |

EPO FORM P0459

For more details about this annex : see Official Journal of the European Patent Office, No. 12/82